(19) **Europäisches Patentamt / European Patent Office / Office européen des brevets**

(11) **EP 4 740 862 A1**

(12) # EUROPEAN PATENT APPLICATION

(43) Date of publication:
**13.05.2026 Bulletin 2026/20**

(21) Application number: **25166854.7**

(22) Date of filing: **27.03.2025**

(51) International Patent Classification (IPC):
**A61B 5/346** (2021.01)   **A61B 5/372** (2021.01)
**A61B 5/397** (2021.01)   **A61B 5/00** (2006.01)

(52) Cooperative Patent Classification (CPC):
**H03M 1/0836**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **12.11.2024 ES 202430935**

(71) Applicant: **Universidad de Granada
18071 Granada (ES)**

(72) Inventors:
• **DE LA TORRE VEGA, Ángel**
  18071 Granada (ES)
• **ÁLVAREZ RUIZ, Isaac Manuel**
  18071 Granada (ES)
• **MUÑOZ ORELLANA, Juan Antonio**
  18071 Granada (ES)

(74) Representative: **Herrero & Asociados, S.L.
Edificio Aqua - Calle Agustín de Foxá, 4-10, 2ºA
28036 Madrid (ES)**

(54) **AN IMPROVED PROCEDURE FOR REDUCTION OF QUASI-PERIODIC INTERFERENCES**

(57) The procedure is focused on the cancellation of the QPI frequency drift, in order to minimize the spectral width of the interference harmonics and, therefore, to efficiently reduce this interference (i.e. reduction of the QPI components with minimum distortion of the signal of interest). The procedure selects QPI harmonics suitable for the estimation of a time drift associated to the frequency drift; estimates the time drift; transforms the signal to a time-scale where the time drift (and therefore also the frequency drift) is cancelled; efficiently reduces the QPI components with minimal distortion of the signal; and transforms the signal back to the original time-scale, obtaining a signal substantially free of QPI.

EP 4 740 862 A1

**Description**

**FIELD OF THE INVENTION**

The present invention belongs to the field of noise reduction techniques in electronic instrumentation for acquisition of electrical signals (like electrocardiograms -ECG-, electroencephalograms -EEG-, other biopotentials or any other electrical signals) and more particularly to a method and a system for removing or reducing, from electrical signals, quasi-periodic interference (QPI) such as the power line interference (PLI).

**STATE OF THE ART**

Electrical signals are usually affected by quasi periodic interferences (QPI). For example, power line interference (PLI) often degrades low amplitude electrical signals acquired by recording instruments, in spite of different amplifier and shielding designs or proper grounding methods. PLI is a quasi-periodic interference associated to power line (or mains), with nominal fundamental frequency at either 50 Hz or 60 Hz depending on the geographical area. The PLI is observed as a 50 or 60 Hz periodic oscillation superimposed to the signal of interest when the signal is represented as a function of the time. The PLI can also be observed with spectral analysis, as a series of harmonics at the frequencies $k \cdot f_0$ (with k=1, 2, 3, etc.) being $f_0$ the fundamental frequency of the power line (either 50 or 60 Hz).

The problem of QPI and specifically of PLI is relevant in the acquisition of biopotentials (such as electrocardiogram -ECG-, electroencephalogram -EEG-, electromyogram - EMG-, etc.) or other low amplitude electrical signals, because usually the PLI severely degrades those signals. For this reason, several digital solutions are known in the art, aimed to remove or at least to reduce the PLI components from the digital recorded signal.

For example, notch filters are applied to attenuate the frequency components around the nominal frequency ($f_0$) and/or several harmonics ($2 \cdot f_0$, $3 \cdot f_0$, etc.) of the PLI (for example document US9247911B2). However, notch filters can cause significant distortion to the recovered signals. Adaptive filters are also applied to adapt to fluctuations in the fundamental frequency and therefore to improve the cancelation of the PLI while reducing the distortion in the recovered signal (for example documents US8761867B2; WO2020197490A). Another group of methods include procedures for the estimation of the amplitude, frequency and phase of the PLI at one or several harmonics of the PLI, combined with digital subtraction procedures (for example documents US5278777A; US7894885B2).

The efficiency of the methods for PLI reduction is mainly limited due to the fluctuation of the PLI frequency with respect to its nominal frequency. The fundamental frequency of the PLI fluctuates slowly (with typical frequency drifts in the range of tens to hundreds of milli-Hertz) and this causes an expansion of the frequency peaks in the spectrum. It is important to note that the frequency expansion of the harmonics associated to this frequency drift is proportional to the index of the harmonic (for example, a frequency drift of 80 mHz at $f_0$=50 Hz, causes a drift of 1.6 Hz in the 20th harmonic at 1000 Hz). When methods based on notch filters are applied, the expansion of the harmonics constrains the design of the notch filters and causes important distortion in the signal of interest (if the removed bandwidth is wide) or inefficient PLI reduction (if the removed bandwidth is narrow). On the other hand, in digital subtraction methods, the frequency fluctuation makes the estimation of the PLI components inaccurate (because PLI cancellation is based on a fixed average frequency but PLI frequency fluctuates). Finally, methods based on adaptive filters are able to provide appropriate PLI reduction under fluctuating power line frequency, but only if frequency fluctuations are very slow (because if frequency fluctuation is fast, the frequency bands to be removed are wide and this causes important distortions in the filtered signal).

Hence, there is a need for a robust and adaptive solution which effectively and precisely reduces QPI even under conditions of fluctuating frequency, without compromising the integrity of the original signal (signal of interest).

**SUMMARY OF THE INVENTION**

The present invention proposes a method and system which efficiently reduce the QPI with minimal distortion of the signal of interest, solving the above stated problems of the prior art techniques. In order to do it, the time drift associated with the frequency and phase drift of the QPI is estimated. Then the time scale is transformed in order to compensate the time drift (and consequently cancel the frequency and phase drift). After the compensation of the time drift, the harmonics of the QPI concentrate the energy at their respective nominal frequency (because in the compensated time scale the interference is not quasi-periodic but periodic), which enables an efficient QPI reduction either by using very narrow notch filters in the time domain or by canceling a few frequency components in the frequency domain. After removing the QPI in the compensated time scale, the signal is transformed back to the original time scale.

The first aspect of the present invention is a method to accurately reduce quasi-periodic interferences (QPI). These QPI interferences may be of any type, for example, the power line interference (PLI) usually contaminating biopotentials (like electrocardiograms - ECGs-, electroencephalograms -EEGs-, electromiograms -EMGs-, etc.) and other electrical signals acquired with high gain instrumentation amplifiers or high input impedance amplifiers.

In an embodiment, the estimation of the time drift may be based on quadrature phase demodulation (a procedure usually applied in the context of analog and digital communications for frequency and phase demodulation, and also for coherent amplitude demodulation) applied to one or several harmonics of the QPI.

In an embodiment the harmonic or harmonics used for the estimation of the time drift may be selected with a criterion of optimal quality (maximum signal to noise ratio) in the frequency domain.

In an embodiment the transformation of the signal between the original and the corrected time scale and vice-versa may be done by interpolation (for example, cubic spline interpolation or any other).

In an embodiment the reduction of the QPI may be performed either in the time domain with notch comb filters, or in the frequency domain by applying a discrete Fourier transform (DFT) to the signal and cancelling those frequency components corresponding to the harmonics of the QPI.

In one example of implementation, the proposed procedure involves three DFT operations (implemented with the fast Fourier transform algorithm, FFT): a first one for the selection of the harmonic to be used for the time drift estimation; the second one to transform the signal, after the time drift compensation, to the frequency domain; and the third one (an inverse DFT) to transform the spectrum, after the cancellation of the harmonics of the QPI, back to the time domain. The procedure also includes two cubic spline interpolations applied to the signal: the first one to transform the signal from the original time scale to the corrected time scale (in which the frequency and phase drift is compensated and the QPI can efficiently be cancelled); and the second one to transform the signal (after the QPI cancellation) from the corrected time scale back to the original time scale. This is merely a non-limiting example, and in other embodiments, the procedure may be carried out in various alternative ways.

The selection of the harmonics (to be used for the time drift estimation) can be restricted according to particular characteristics of the signal of interest. That is, the selection of the one or more harmonics to be used for the phase and time drift estimation may be restricted to a specific frequency range according to the frequency content of the signal of interest. For example, in the case of ECG signals (with most of the energy below 500 Hz) affected by interference from the power line, the selection of the harmonics can be restricted to the range 0-500 Hz, in order to optimize the PLI reduction to the frequency range of interest. Additionally, in the case of signals acquired at high sampling rate (for example, EEG signals sampled at 16 kHz and affected by PLI), some practical limitations (related to stability of the low-pass filter used for the phase drift estimation) suggest the restriction of the harmonic selection to a minimum frequency (for example 250 Hz).

In its simplest implementation, the time drift estimation is based on one harmonic (e.g. the one with the best quality in the range for harmonic selection). However, since the phase drift estimation is affected by some uncertainty (due to the presence of other signals, different to the QPI, with some energy in the frequency range around the selected harmonic), in order to optimize the estimation of the time drift, it can be estimated independently at several harmonics (preferably, those with the highest signal-to-noise ratio). This way, a more accurate estimation of the time drift can be achieved by combining the estimations from the different selected harmonics, either by a simple average (if the selected harmonics present a similar quality) or with a weighted average (with weights proportional to the signal-to-noise ratio of each selected harmonic).

For the compensation of the time drift (the transformation from the original time scale to the time scale where the time drift has been corrected, the corrected time scale), for example a cubic spline interpolation may be used. However, a simpler interpolation (e.g. linear interpolation) or a more elaborated (e.g. including resampling at higher sampling frequency) can alternatively be applied depending on the required accuracy or limitations related to computational cost.

The procedure for QPI reduction can be implemented as an off-line algorithm: that is, from the complete input signal affected by QPI, the algorithm carries out each step sequentially (using the whole input signal at each step and providing the whole result for this step before starting with the next one), and provides the complete output signal after all the steps of the QPI cancellation procedure are completed. The procedure can alternatively be implemented as an on-line algorithm: that is, each step is carried out using the available portion of the input signal (for example, up to a given sample of the input signal from a running time-buffer) and provides a portion of its partial result for the next step (with some delay); the last step of the QPI cancellation procedure provides the output signal in real time with some cumulated delay (which is mainly dominated by the bandwidth of the frequency bands to be removed).

Due to the frequency and phase drift of the QPI, the efficiency of the QPI cancellation methods in the state of the art is limited compared to that proposed in the present invention. Without the proposed compensation of the time drift, the harmonics are spread around their nominal frequencies, and the cancellation of the QPI must be done either with wide stop-band filters (to effectively remove the QPI at the cost of generating large distortion in the signal of interest) or with narrow stop-band filters (reducing the distortion in the signal of interest but not removing the QPI effectively in the case of important frequency drift). The solution of the present invention improves the prior art QPI cancellation methods because after the compensation of the time drift associated to the frequency and phase drift of the QPI, the frequency of the QPI does not fluctuate and all the QPI harmonics are concentrated at their respective nominal frequencies, therefore making the cancellation of those harmonics more efficient (i.e. better cancellation of the QPI with minimal distortion in the signal of interest), overcoming the drawbacks of existing solutions in the prior art.

In a second aspect, the invention refers to a system comprising means to acquire electrical signals and means to apply the method for QPI reduction of the first aspect of the invention.

In a third aspect, the invention refers to a computer program implementing the method of the first aspect of the invention. This aspect refers to computer programs comprising instructions for making a computer (or any other information processing system) carry out the procedure of the invention for QPI reduction.

The computer programs may be in the form of source code, object code or an intermediate code between source code and object code, such as in partially compiled form, or in any other form suitable for use in implementing the processes according to the invention. In particular, the computer programs also encompass cloud applications implementing the procedure of the invention. These programs may be arranged on or within a medium suitable for reading them, hereinafter referred to as "carrying medium" or "carrier". The carrying medium may be any entity or device capable of carrying the program. When the program is incorporated in a signal that can be transported directly by a cable or other device or medium, the carrying medium may consist of said cable or other device or medium. Alternatively, the carrying medium can be an integrated circuit in which the program is included, the integrated circuit being adapted to execute, or to be used in the execution of, the corresponding processes.

For example, the programs may be embedded in a storage medium such as a ROM, CD-ROM or semiconductor ROM, a USB memory stick, or a magnetic recording medium such as a floppy disk or hard disk. Alternatively, the programs may be supported by a transmittable carrier signal. For example, this may be an electrical or optical signal which may be carried by electrical or optical cable, radio, or any other means.

In this regard, another object of the invention is a computer-readable storage medium (non-transitory) comprising program instructions capable of causing a computer to carry out the procedure of the invention.

And another object of the invention relates to a transmittable signal comprising program instructions capable of causing a computer to carry out the method of the invention. The application relates to an invention as set out in the appended claims.

**BRIEF DESCRIPTION OF DRAWINGS**

To complete the description and with the object of assisting in a better understanding of the characteristics of the invention, in accordance with a preferred example of practical embodiments thereof, accompanying said description as an integral part thereof, is a set of drawings wherein, by way of illustration and not restrictively, the following has been represented related to implementations of the invention:

FIGURE 1 shows a schematic representation of a system for acquiring biopotentials which implements the procedure for QPI reduction according to one embodiment of the invention.

FIGURE 2 shows a schematic representation of the procedure for QPI reduction according to one embodiment of the invention.

FIGURE 3 shows the listing of an M-file (implemented as a MATLAB® function or M-function) with instructions that provide the procedure for QPI reduction according to one embodiment of the invention. This M-function has been applied to reduce the power line interference from the ECG and EEG signals included as examples.

FIGURE 4 shows an ECG signal (amplitude, in millivolts, as a function of time, in seconds), that is, the raw digital signal $y[n]$ affected by PLI before the application of the procedure for PLI reduction.

FIGURE 5 shows the power spectral density (PSD, amplitude in dB) as a function of the frequency (in Hz) of the ECG signal in FIGURE 4.

FIGURE 6 shows the phase drift $\varphi[n]$ (in radians) as a function of the time, estimated from the 7th harmonic (350 Hz) of the PLI in the ECG signal represented in FIGURE 4.

The phase drift is estimated by applying the proposed procedure based on quadrature phase demodulation, according to one preferred embodiment thereof.

FIGURE 7 shows the time drift $dt[n]$ (in ms) of the PLI in the ECG (as a function of the time) estimated from the phase drift shown in FIGURE 6.

FIGURE 8 shows portions of the PSD corresponding to the fundamental frequency at 50 Hz (left panels) and corresponding to the 7th harmonic at 350 Hz (right panels), obtained from the ECG signal represented in FIGURE 4.

The FIGURE 8A represents the PSD portions obtained from the raw ECG $y[n]$, while the FIGURE 8B represents the PSD portions obtained from the same ECG after the cancellation of the estimated time drift (i.e. obtained from the Fourier transform $Y_c[m]$ of the digital signal in the corrected time scale $y_c[n]$).

FIGURE 9 shows the ECG signal $x[n]$ after the application of the proposed procedure for PLI reduction, obtained from the same ECG signal $y[n]$ represented in FIGURE 4.

FIGURE 10 shows the PSD (amplitude in dB as a function of the frequency in Hz) of the ECG signal in FIGURE 9, that is, the ECG signal after the application of the proposed procedure for PLI reduction.

FIGURE 11 shows a detail of the same ECG signal (presented in FIGURE 4) after the application of three methods for PLI reduction: IIR notch comb filter with Q-factor equal to 10 (top panel); IIR notch comb filter with Q-factor equal to 40 (central panel); and the proposed procedure (bottom panel).

FIGURE 12 represents the PSD (amplitude in dB as a function of the frequency in Hz) of the ECG signals after PLI reduction based on IIR notch comb filters using Q-factor equal to 10 (FIGURE 12A) and Q-factor equal to 40 (FIGURE 12B).

FIGURE 13 shows portions of the PSD corresponding to the 15th harmonic of the PLI, at 750 Hz (left panels) and corresponding to the 27th harmonic, at 1350 Hz (right panels), estimated from an EEG signal recorded for the estimation of auditory evoked potentials.

The FIGURE 13A represents portions of the PSD obtained from the raw EEG y[n], while the FIGURE 13B represents portions of the PSD obtained from the same EEG after the correction of the time drift $y_c$[n].

FIGURE 14 shows the EEG signals (amplitude in microvolts as a function of the time) before (FIGURE 14A, y[n]) and after (FIGURE 14B, x[n]) the application of the proposed procedure for PLI reduction according to one preferred embodiment thereof.

FIGURE 15 shows the PSD (amplitude in dB as a function of the frequency) of the EEG signals in FIGURE 14, before (FIGURE 15A) and after (FIGURE 15B) the application of the proposed procedure for PLI reduction according to one preferred embodiment thereof.

FIGURE 16 shows the auditory evoked responses obtained from the same EEG signal, before (FIGURE 16A) and after (FIGURE 16B) applying the proposed procedure for PLI reduction according to one preferred embodiment thereof.

## DETAILED DESCRIPTION OF THE INVENTION

The present invention proposes a procedure to accurately reduce a quasi-periodic interference (QPI) contaminating a digital signal. The digital signal affected by QPI, y[n], is obtained from an analog electrical signal y(t), which may be conditioned by an instrumentation preamplifier (which usually already includes electronic procedures and appropriate grounding circuits to reduce the common-mode interference and the QPI) and converted into a digital signal y[n] by an analog-to-digital converter (ADC). The digital signal y[n] is transferred to a device, such as a computer or other digital system, where it can be processed, displayed, monitored, analyzed, transmitted and/or stored. In an embodiment, this computer may also apply the procedure for QPI reduction according to the present invention.

Despite the specific amplifier and shielding designs or proper grounding methods, the digital signal y[n] is usually affected by a QPI (such as the PLI), and methods for QPI reduction are necessary in the digital system to improve the quality of the digital signal. The QPI consists in an additive interference superimposed to the signal of interest, characterized by its periodicity (corresponding to the nominal fundamental frequency $f_0$) in the time representation, and by the presence of the harmonics at the frequencies $k \cdot f_0$ (where k represents the harmonics indexes with k=1, 2, 3, etc.) in the spectral representation. However, these periodic interferences are usually not perfectly periodic but quasi-periodic, sometimes due to fluctuations of the frequency and phase of the interference source, sometimes due to fluctuations of the sampling frequency of the ADC converter, or due to the limited stability of the clocks included in the electronic systems involved in the signal acquisition. In the case of the PLI, even though its fundamental frequency is reasonably stable, it slowly fluctuates around the nominal value $f_0$, with frequency drifts typically of several tens of milli-Hz, and this limits the efficiency of most of the methods for PLI reduction. The objective of the present invention is to avoid this limitation to efficiently reduce the quasi-periodic interference.

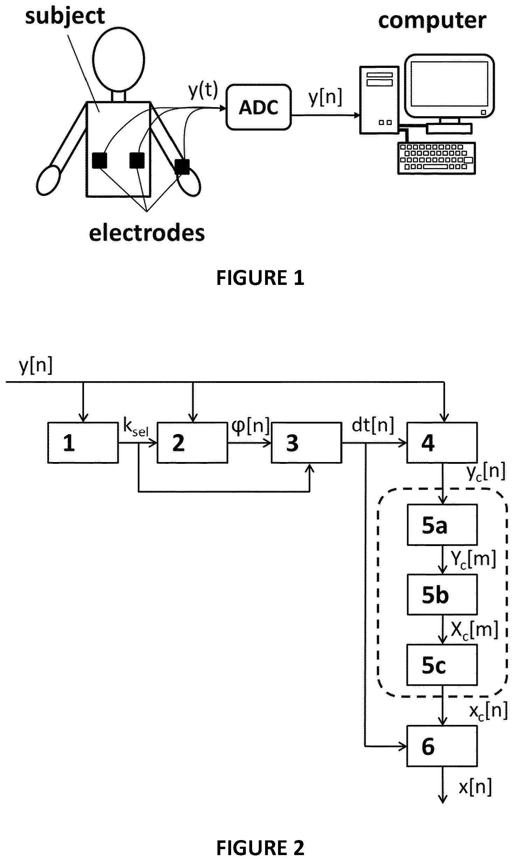

FIGURE 1 shows a schematic illustration of a system for acquiring single-channel electrocardiogram signals from a subject which implements the procedure for QPI reduction according to one embodiment of the invention. The system comprises: electrodes for the acquisition of the biopotentials from an explored subject; an analog to digital converter (ADC) with appropriate preamplification before the conversion, which receives as an input an analog electrical signal y(t) acquired by the electrodes and provides as an output a digital signal y[n]; and a computer (general speaking one or more electronic processors) with a program to implement the procedure for QPI reduction applied to the digital signal y[n]. The digital signal y[n], which is considered as the input for the disclosed QPI reduction procedure, is processed with the computer in order to reduce the QPI and provide a clean (with minimum or non-QPI presence) digital signal x[n].

In this example, there are three electrodes to acquire the electrical signal, (one used either as ground or common-mode sense, placed at one wrist, and the other two, placed at the chest, defining a differential channel and providing the analog signal). This is only an example and, in other embodiments, there can be a different number of electrodes and/or located in other positions of the explored subject.

The first aspect of the present invention is a method (also called procedure) for the accurate reduction of quasi-periodic interferences (QPI), such as the power line interference (PLI), usually contaminating the electrical signals when they are acquired using high gain instrumentation amplifiers or high input impedance amplifiers or other electronic acquisition systems. The procedure of the invention is applied to a digital signal y[n] contaminated by a QPI with nominal frequency $f_0$, and is focused on the estimation and compensation of the phase drift (associated to the frequency fluctuations) affecting the QPI and limiting the efficiency of other methods for QPI reduction.

In its general approach, the procedure of the invention comprises the following steps:

A. Estimation of the time drift associated with the frequency and phase drift of the QPI.

B. Transformation of the time scale, in order to compensate the time drift (and consequently cancel the frequency and phase drift).

C. Reduction of the QPI either by applying very narrow notch filters (tuned at $f_0$ and its harmonics) in the time domain, or by cancelling a few frequency components (those corresponding to $f_0$ and its harmonics) in the frequency domain, in order to reduce the QPI interference with minimum distortion of the signal of interest, where the spectral width of the bands to be removed is constrained by the duration of the signal and/or the maximum delay tolerated for the procedure.

D. After removing the QPI in the compensated time scale, transformation of the signal back to the original time scale.

In the step (C) of the procedure, "very narrow notch filters" are understood as notch filters with a stop-band narrow enough in order to minimize the distortion (associated to the removed bandwidth) in the signal of interest. Similarly, the cancellation of only "a few frequency components" minimizes the distortion in the signal of interest. Since the frequency and phase drift are cancelled in step (B), an effective QPI reduction is achieved by removing very narrow bandwidths around each harmonic of the QPI. The spectral width of the bands to be removed is constrained by the duration of the signal and/or the maximum delay tolerated for the procedure.

In a more detailed embodiment, the procedure of the invention comprises the following steps, schematically described in FIGURE 2 (this is only a non-limitative example and, in other embodiments some of these steps may not be performed, performed in a different way and/or other steps may be performed)):

1) Selection of at least one harmonic $k_{sel}$ to be used for the estimation of the phase drift of the QPI. In an embodiment, the selected harmonic(s) has a power spectral density higher than that of the background signal in the frequency band, and preferably at least 3 dB higher than that of its spectral background.

2) Estimation of the phase drift $\varphi[n]$ of the QPI with respect to the nominal frequency $k_{sel} \cdot f_0$ for each selected harmonic, for example using quadrature phase demodulation using the selected harmonic(s).

3) Estimation of the time drift associated to the phase drift of the QPI at each selected harmonic $k_{sel}$ and, from them, estimation of the time drift dt[n] of the QPI. For example, if more than one harmonic has been selected an average time drift may be used.

4) Time correction in the digital input signal y[n] using the estimated time drift dt[n]. In other words, the time drift dt[n] from the digital signal y[n] is compensated by transforming the signal to a corrected time scale, obtaining a signal $y_c[n]$ in a corrected time scale and without frequency and phase drift in the QPI.

5) Cancellation of the harmonics of the QPI from the signal in the corrected time scale, either by applying very narrow notch filters (tuned at $f_0$ and its harmonics) in the time domain, or by cancelling a few frequency components (those corresponding to $f_0$ and its harmonics) in the frequency domain. This way the reduction of the QPI interference is performed with minimum distortion of the signal of interest, where the spectral width of the bands to be removed is constrained by the duration of the signal and/or the maximum delay tolerated for the procedure. This step provides the clean signal $x_c[n]$ in the corrected time scale.

In the embodiment shown in figure 2, this QPI reduction is made by cancelling frequency components in the frequency (spectral) domain, and comprises: 5a) discrete Fourier transform of the digital signal in the corrected time scale in the time domain $y_c[n]$, to obtain signal $Y_c[m]$ in the frequency domain; 5b) cancellation of the QPI harmonics in the spectral domain to obtain a clean signal $X_c[m]$ in the frequency domain in the corrected time scale, and 5c) inverse discrete Fourier transform of $X_c[m]$ to obtain the clean signal in the corrected time scale ($x_c[n]$) in the time domain.

6) Reverse compensation of the time drift dt[n] for the clean signal $x_c[n]$ to obtain the clean signal in the original time scale x[n]. This signal x[n] is provided as the result of the proposed procedure.

In accordance with the general procedure outlined earlier, steps 1, 2, and 3 will be executed to perform the time drift estimation of general step A, while steps 4, 5, and 6 correspond, respectively, to general steps B, C, and D. In the following, the steps included in the procedure are described in detail, according to embodiments of the invention.

Step 1) Selection of at least one suitable harmonic $k_{sel}$ to be used for the estimation of the phase drift (and from it, the time drift) of the QPI, wherein the selected harmonic(s) has a power spectral density higher than that of the background signal in the frequency band, and preferably at least 3 dB higher than that of its spectral background.

In a first embodiment of this step, the harmonic(s) to be used for the estimation of the phase drift of the QPI may be selected with a criterion of maximum quality (i.e. highest signal-to-noise ratio, SNR) which is estimated based on spectral analysis. In this case, the selection of the harmonic(s) $k_{sel}$ comprises the following sub-steps:

1.a) Estimation of the Discrete Fourier Transform (DFT) Y[m] of the digital signal y[n]. The DFT can efficiently be computed with the well-known fast Fourier transform (FFT) algorithm.

1.b) For each harmonic k (between k=1 and k=$f_s$/(2·$f_0$), where $f_s$ is the sampling frequency), definition of a maximum expected frequency excursion $B_k$ of the harmonic with respect to its nominal frequency k·$f_0$, preferably between k·$f_0$/1000 and k·$f_0$/100 and more preferably between k·$f_0$/333 and k·$f_0$/200. In the case of PLI $f_0$ is either 50 Hz or 60 Hz, and since the maximum frequency drift of the fundamental frequency is typically below 0.15 Hz, a maximum excursion $B_k$=k·0.2 Hz usually guarantees that all the energy of the harmonic is contained in the interval [k·$f_0 \pm B_k$].

1.c) For each harmonic k, to estimate the energy of the harmonic $E_k$ from the frequency components in the interval [k·$f_0 \pm B_k$], and to estimate the energy of the noise affecting the harmonic $E_{nk}$ (i.e. the energy of the spectral background) from the frequency components in the intervals [k·$f_0$ - 2·$B_k$, k·$f_0$ - $B_k$] and [k·$f_0$ + $B_k$, k·$f_0$ + 2·$B_k$] (i.e. a disjoint spectral portion around the harmonic interval with the same spectral width).

1.d) For each harmonic k, to estimate the signal-to-noise ratio (SNR) as the ratio of the harmonic energy to the noise energy, $SNR_k = E_k/E_{nk}$.

1.e) The selection of the harmonic(s) is based on their SNR. Usually, the harmonic(s) with the largest $SNR_k$ are selected, i.e. the one (or these ones) less affected by the noise, and therefore the one (or these ones) providing the most accurate estimation of the time drift. In an embodiment, a certain number (preestablished design parameter) of harmonics with the largest SNR are selected; in other embodiment, the harmonics with SNR above a threshold (e.g. SNR>3dBs) are selected.

Note that if no harmonic provides a $SNR_k$ higher than 3 dB, then the magnitude of the QPI is not relevant and therefore, the expected benefit from the application of the QPI cancellation procedure is not significant.

In another embodiment of this step, depending on the nature of the signal of interest and its spectral content, the selection of the harmonic is constrained to a specific range, in order to optimize the procedure to the frequency range of interest. For example, for ECG signals (taking into account the spectral content of this type of signal), the selection of the harmonic(s) can be restricted to the range [0-500] Hz.

In another embodiment of this step, for signals acquired at high sampling rate, the harmonic(s) selection can be restricted to a minimum frequency in order to avoid practical problems related to the stability of the low-pass filter used for the phase drift estimation (in step 2 of the procedure). The minimum frequency considered for the harmonic selection is that one providing a stable low-pass filter at the considered sampling frequency. For example, for a signal sampled at 16 kHz, the reported examples (using 64-bit floating point representation of the filter coefficients) suggest the restriction of the harmonic selection to a minimum frequency of 250 Hz.

In another embodiment of this step, in the case of stationary signal and QPI interference, the harmonic(s) can be selected from portions of the recorded input signal instead of performing the selection from the whole signal.

This step provides as output the harmonic(s) $k_{sel}$ selected for the phase drift estimation. It can be said that $k_{sel}$= $k_{sel1}$ $k_{sel2...}$ $k_{selH}$, where $k_{sel1}$ $k_{sel2...}$ $k_{selH}$ are the index of each selected harmonic and being H>=1 the amount of harmonics selected in this step. That is, $k_{sel}$ may be a single value (if only one harmonic is selected) or a group of several values if more than one harmonic is selected.

Step 2) Estimation of the phase drift φ[n] of the QPI with respect to the nominal frequency $k_{sel}$·$f_0$ <u>for each selected harmonic.</u>

In an embodiment, the estimation of the phase drift φ[n] for each selected harmonic $k_{selh}$ (h=1... H) comprises a quadrature phase demodulation of the signal y[n] around the harmonic of frequency $k_{selh}$·$f_0$, using a pair of carriers of frequency $k_{selh}$·$f_0$ in quadrature. Quadrature phase demodulation is a well-known procedure usually applied to analog or digital signals, in the context of modern communications, as a phase demodulation procedure for phase modulation (PM) and frequency modulation (FM) communications, as well as for their respective digital communications: phase shift keying (PSK) and frequency shift keying (FSK), and also for coherent demodulation of amplitude modulation (AM) and amplitude shift keying (ASK) signals.

In one embodiment of this step, the estimation of the phase drift $φ_h$[n] with respect to one selected harmonic $k_{selh}$·$f_0$ comprises the following sub-steps:

2.a) To obtain the base-band in-phase component $y_i$[n] by multiplying the digital signal y[n] with the in-phase carrier $\cos(2·\pi·k_{selh}·f_0·n/f_s)$. Similarly, to obtain the base-band quadrature component $y_q$[n] by multiplying the digital signal y[n] with the quadrature carrier $-\sin(2·\pi·k_{selh}·f_0· n/f_s)$.

2.b) To combine the in-phase $y_i$[n] and quadrature $y_q$[n] base-band components into the complex base-band signal $y_{cbb}$[n]=$y_i$[n] + j $y_q$[n], being j the imaginary unit of the complex numbers.

2.c) To filter the complex base-band signal using a low-pass filter with an appropriate cut-off frequency according to the maximum expected frequency excursion for the selected harmonic (defined in step 1.b), therefore obtaining the filtered complex base-band signal $y_{fcbb}[n]$.

2.d) To estimate the phase drift $\varphi[n]$ as the phase (or argument) of the filtered complex base-band signal $y_{fcbb}[n]$:

$$\varphi_h[n] = \arctan(\mathrm{imag}(y_{fcbb}[n])/\mathrm{real}(y_{fcbb}[n])) \quad \text{or} \quad \varphi_h[n] = \mathrm{angle}(y_{fcbb}[n])$$

2.e) To unwrap the phase drift $\varphi[n]$ in order to provide continuity to the estimated phase and avoid phase jumps (close to either $\pi$ or $2\cdot\pi$ radians depending on the expression applied for the phase estimation).

In another embodiment of this step, the sub-steps 2.a and 2.b can equivalently be performed by multiplying the signal y[n] with the complex carrier $\exp(-j\cdot 2\cdot\pi\cdot k_{selh}\cdot f_0\cdot n/f_s)$:

$$y_{cbb}[n] = y[n]\cdot \exp(-j\cdot 2\cdot\pi\cdot k_{selh}\cdot f_0\cdot n/f_s)$$

This step, is performed for every harmonic $k_{selh}$, h=1... H and provides as output the instantaneous unwrapped phase drift $\varphi_h[n]$ of the selected harmonic h with nominal frequency $k_{selh}\cdot f_0$, for each sample of the signal y[n].

Step 3) Estimation of the time drift associated to the phase drift of the QPI at each selected harmonic $k_{sel}$ and, from these estimated values, estimation of the time drift dt[n] of the QPI.

In one embodiment of this step, if only one harmonic is selected in step 1, i.e. (H=1, $k_{sel}= k_{sel1}$), the estimation of the time drift dt[n] is direct from the phase drift $\varphi[n]$ obtained in step 2 and the frequency of the harmonic $k_{sel}\cdot f_0$ as:

$$dt[n] = \varphi[n]/(2\cdot\pi\cdot k_{sel}\cdot f_0)$$

This step provides as output the time drift dt[n] for each sample of the signal y[n].

In another embodiment of this step, if several harmonics are selected (i.e. H>1) and the quality of these harmonics is similar (i.e. their respective SNR estimated in the first step are in an certain interval, for example of 6 dBs, and more preferably in an interval of 3 dBs), the time drift dt[n] can be estimated, for example, as the average of the individual estimations of the time drift for each harmonic.

In another embodiment of this step, if several harmonics are selected, the time drift can be estimated as a weighted average of the individual estimations of the time drift for each harmonic, using appropriate weights. Since the standard error of the individual time drift estimations for each harmonic is inversely proportional to the square root of the SNR (as stated for example in Medina-Rodriguez et al. "Direct estimation of the standard error in the phase-resolved luminescence measurements. Application to an oxygen measurement system") and also inversely proportional to the harmonic index, the appropriate weights to be applied for an optimal average are proportional to the SNR and, more preferably, are proportional to the SNR and to the square of the harmonic index (as stated for example in Medina-Rodriguez et al., "Improved multifrequency phase-modulation method that uses rectangular-wave signals to increase accuracy in luminescence spectroscopy" or "Real-time optimal combination of multifrequency information in phase-resolved luminescence spectroscopy based on rectangular-wave signals"), then the following weight $w_h$ could be used for every selected harmonic $k_{selh}$:

$$w_h= SNR_h\cdot k_{selh}^2$$

and the time drift will be calculated as $dt[n] = \mathrm{sum}(w_h\cdot dt_h[n]) / \mathrm{sum}(w_h)$ for h=1... H, where $dt_h[n] = \varphi_h[n]/(2\cdot\pi\cdot k_{selh}\cdot f_0)$, where $dt_h[n]$ is the time drift of each selected harmonic h, $\varphi_h[n]$ is the estimated phase drift of each selected harmonic h and $k_{selh}$ is the index of each selected harmonic h.

Step 4) Compensation of the time drift dt[n] from the digital signal y[n] by transformation of the signal to a corrected time scale, obtaining a signal $y_c[n]$ in a corrected time scale and without frequency drift in the QPI.

In one embodiment, the correction of the time drift from the digital signal (or equivalently, the transformation of the digital signal to a corrected time scale where the estimated phase drift is cancelled) comprises the following sub-steps:

4.a) For each sample n of the signal, to estimate the original time t[n] and the corrected time $t_c[n]$, respectively, as: $t[n] = n/f_s$ and $t_c[n] = t[n]-dt[n]$ (being $f_s$ the sampling rate and dt[n] the time drift for each sample, estimated from the phase drift in the previous step).

4.b) From the pairs (t[n],y[n]) and using the corrected time $t_c[n]$, to estimate the signal in the corrected time scale $y_c[n]$

by interpolation.

This step provides as output the digital signal $y_c[n]$, in the corrected time scale, where the phase drift (and therefore also the frequency drift) of the QPI is cancelled.

This is only a non-limitative example and the correction of the time drift from the digital signal can be made in any other way. For example, in one preferred embodiment of this step, the estimation of the signal in the corrected time scale $y_c[n]$ is obtained by cubic spline interpolation. Or in another embodiment of this step, the estimation of the signal in the corrected time scale $y_c[n]$ is obtained by linear interpolation or other simple interpolation procedure, thus providing a less accurate compensation of the time drift but with significantly reduced computational requirements. In another embodiment of this step, the estimation of the signal in the corrected time scale $y_c[n]$ is obtained by a more complex interpolation method (including for example oversampling of the digital signal), thus requiring more computational resources but providing a slightly more accurate compensation of the time drift.

Step 5) Cancellation of the harmonics of the QPI from the signal in the corrected time scale.

Since the frequency drift of the QPI is cancelled in the digital signal $y_c[n]$ after the step 4, the harmonics of the QPI are narrow spectral lines, and therefore the harmonics can be cancelled efficiently (i.e. an appropriate cancellation of the QPI with minimum distortion of the signal of interest can be achieved).

In one embodiment of this step, the harmonics of the QPI are cancelled in the spectral representation (i.e. in the frequency domain) according to the following sub-steps:

5.a) To obtain the spectrum of the signal in the corrected time scale $Y_c[m]$ by applying a DFT (Discrete Fourier Transform) to the signal in the corrected time scale $y_c[n]$.

5.b) To remove the harmonics of the QPI by making null those spectral components in the spectrum $Y_c[m]$ at a spectral distance to the frequency of each harmonic $k$, $k \cdot f_0$, smaller than a spectral threshold df. This implements a narrow stop-band notch comb filter in the frequency domain and provides the spectrum of the clean signal in the corrected time scale $X_c[m]$. This threshold df may be defined for example as the maximum expected semi-width of the harmonics after the cancellation of the time drift, the spectral threshold df being at least half of the inverse of the duration of the signal $y[n]$ (i.e. corresponding to the spectral resolution provided by the duration of the input signal).

5.c) To obtain the clean signal in the corrected time scale $x_c[n]$ by applying an inverse discrete Fourier transform (iDFT) to the spectrum $X_c[m]$.

The appropriate spectral threshold df (for cancelling spectral components corresponding to the harmonics of the QPI) depends on the nature of the interference and that of the signal, and also on the delay tolerated for the procedure. For example, in the case of biopotentials such as ECG, EEG, etc. affected by PLI, the spectral threshold df (applied to each harmonic) is preferably in the range between 0.025 and 0.25 Hz (requiring delays between 10 and 1 seconds, respectively) and more preferably in the range between 0.08 and 0.12 Hz (requiring delays between 3.1 and 2.1 seconds, respectively).

In an embodiment, before this step, the signal in the corrected time $y_c[n]$ is truncated to an integer number of fundamental periods of the QPI (according to the nominal fundamental frequency of the QPI), because this way all the energy of each harmonic is concentrated in just one component of the spectrum (and spectral scalloping effect is avoided).

This explained way of cancelling the harmonics of the QPI in the frequency domain is only a non-limitative example and cancellation can be made in any other way. For example, both the DFT and the iDFT transformations can equivalently be implemented with the corresponding fast Fourier transform algorithms (FFT and iFFT).

This step provides as output the clean digital signal $x_c[n]$ in the corrected time scale, that is, the digital signal in which the QPI is reduced or cancelled, but in a time scale where the estimated time drift of the QPI is cancelled.

In another embodiment of this step the harmonics of the QPI are cancelled by applying a notch comb filter tuned at the nominal fundamental frequency of the QPI and its harmonics (with appropriate quality factor) to the signal in the corrected time scale $y_c[n]$, i.e. in the time domain. The output of the filter is the clean digital signal $x_c[n]$ in the corrected time scale. The appropriate quality factor Q of the notch comb filter depends on the nature of the interference and the nature of the signal and also on the delay tolerated for the procedure or, in other words, the quality factor should be consistent with the duration of the signal and the delay tolerated for the procedure. For example, in the case of biopotentials such as ECG, EEG, etc. affected by PLI, the quality factor Q of the notch comb filter for cancelling spectral components corresponding to the harmonics of the PLI is preferably between 25 and 800 and more preferably between 50 and 200.

Step 6) Reverse compensation of the time drift dt[n] for the clean signal $x_c[n]$ to obtain the clean signal in the original time scale x[n], provided as the result of the proposed procedure.

In order to restore the clean signal to the original time scale, the time scale must be transformed from the corrected time scale back to the original time scale.

In one embodiment the transformation of the clean signal in the corrected time scale $x_c[n]$ into the clean signal in the original time scale $x[n]$ is obtained by interpolation from the pairs $(t_c[n], x_c[n])$ and using the original time values $t[n]$, where as stated for step 4, $t[n] = n/f_s$ and $t_c[n] = t[n]-dt[n]$. This step provides as output the clean digital signal $x[n]$ (i.e. where the QPI is reduced or cancelled) in the original time scale, provided as the result of the proposed procedure.

This is only a non-limitative example and the correction of the time drift from the digital signal can be made in any other way. For example, in one preferred embodiment of this step, the estimation of the clean signal in the original time scale $x[n]$ is obtained by cubic spline interpolation. Or in another embodiment of this step, the estimation of the clean signal in the original time scale $x[n]$ is obtained by linear interpolation or other simple interpolation procedure, thus providing a less accurate estimation but with significantly reduced computational requirements. In another embodiment of this step, the estimation of the clean signal in the original time scale $x[n]$ is obtained by a more complex interpolation method (including for example oversampling), thus requiring more computational resources but providing a slightly more accurate estimation.

In an embodiment of the procedure, all the previously described steps are performed as an off-line algorithm. That is, under this approach, each step of the procedure is applied using the complete input signal to be processed:

- From the complete digital input signal $y[n]$ of a specific duration, the harmonic(s) $k_{sel}$ to be used for the estimation of the phase drift is (or are) selected according to the step 1 of the procedure.
- From the complete $y[n]$ signal and each selected harmonic(s) $k_{sel}$, the phase drift $\varphi[n]$ is estimated according to the step 2 of the procedure, for all the samples of the input signal.
- From the complete phase drift $\varphi[n]$ at each selected harmonic(s), the time drift $dt[n]$ is estimated according to the step 3 of the procedure, for all the samples of the input signal.
- From the complete time drift $dt[n]$, the signal $y_c[n]$ in the corrected time scale is estimated according to the step 4 of the procedure, for all the samples of the input signal.
- From the complete signal $y_c[n]$ in the corrected time scale, the QPI is cancelled and the clean signal in the corrected time scale $x_c[n]$ is estimated according to the step 5 of the procedure, for all the samples of the input signal.
- And finally, from the complete clean signal in the corrected time scale $x_c[n]$, the clean signal in the original time scale $x[n]$ is estimated according to the step 6 of the procedure, for all the samples of the input signal.

This way, under this embodiment of the procedure, each step is completed for all the samples of the input signal before starting with the next step. Therefore, under this embodiment of the procedure, the execution of each step requires the availability of the complete input signal $y[n]$, and all the samples of the output signal $x[n]$ are provided after the complete input signal is acquired and all the steps of the procedure have finished. In another embodiment of the procedure, the previously described steps are performed as an on-line algorithm, that is, all the steps are applied up to the current available samples of the input signal with some delay depending on the cumulated delay caused in each step of the procedure, therefore providing a real-time output signal with a controlled delay. In other words, each step is running using a portion of the available samples of the input signal (at the current time, the time of execution of the procedure). The result of each step is provided to the next step up to a given time (with a particular delay with respect to the current time), and the last step provides the output signal up to a given time (with a delay equal to the cumulated delays of all the steps) as a real-time procedure. Under the on-line implementation of the procedure, the step 1 (selection of the harmonic(s) to be used for the estimation of the phase drift) can be performed as a preliminary step, since the spectral distribution of the QPI and that of the signal of interest are usually stationary and the harmonic selection is not expected to significantly change during the acquisition of the input signal. Therefore, according to a non-limitative embodiment, the steps of the on-line implementation of the procedure may be:

- From a previous portion of the input signal, the harmonic(s) $k_{sel}$ to be used for the estimation of the phase drift is (or are) selected according to the step 1 of the procedure.
- According to the step 2 of the procedure, at the sample index n, the phase drift $\varphi[n-delay_f]$ is estimated for the selected harmonic(s) from a buffer of samples of the input signal $y[n]$ and with a delay ($delay_f$) related to the length of the impulsive response of the low-pass filter used in the step 2 of the procedure.
- From the phase drift $\varphi_h[n-delay_f]$ at each selected harmonic(s), the time drift $dt[n-delay_t]$ is estimated according to the step 3 of the procedure, with a delay ($delay_t$) equal to the maximum delay for the selected harmonics.
- From the time drift $dt[n-delayt]$, according to the step 4 of the procedure, the signal $y_c[n-delay_y]$ in the corrected time scale is estimated, with a delay ($delay_y$) increased in the number of samples necessary for the interpolation associated to the correction of the time scale.
- From the signal $y_c[n-delay_y]$ in the corrected time scale, the QPI is cancelled using an on-line procedure for QPI cancellation, and the clean signal in the corrected time scale $x_c[n-delay_x]$ is estimated according to the step 5 of the procedure with an additional delay. In the on-line implementation, the QPI cancellation may not be estimated in the frequency domain using a Fourier transform (which requires the complete signal), but with a narrow band notch comb filter. The QPI cancellation based on notch comb filter causes a delay ($delay_x$) in the output signal related to the impulsive response of the filter.

- And finally, from the clean signal in the corrected time scale $x_c[n-delay_x]$, the clean signal in the original time scale $x[n-delay_{output}]$ is estimated according to the step 6 of the procedure, with an additional delay ($delay_{output}$) increased in the number of samples necessary for the interpolation associated to the restoration of the time scale.

This way, under this embodiment of the procedure, each step is completed with a delay with respect to the current sample of the input signal y[n] in a real-time implementation of the algorithm, and the output $x[n-delay_{output}]$ is provided up to a given sample conditioned by the cumulated delay. The cumulated delay is mainly conditioned by the quality factor of the notch comb filter used for the QPI cancellation (since the length of the impulsive response directly depends on this quality factor). The bandwidth of the low-pass filter(s) used in the step 2 is wider (and therefore its contribution to the delay is significantly smaller). The delay associated to the interpolation procedures is also small compared to the delay caused by the filters. In order to avoid phase distortion associated to the application of the filters, linear-phase finite impulsive response (FIR) filters are recommendable. In the case of biopotentials (ECGs, EEGs, etc.) affected by PLI, taking into account the typical bandwidth to be removed for the QPI cancellation (around 0.2 Hz), the impulsive response of linear-phase FIR filters has a duration of around 5 seconds, and a delay slightly larger than 2.5 seconds is reasonable for an on-line (or real-time) implementation of the procedure.

In another embodiment of the on-line implementation of the procedure, the harmonic selection can be periodically updated.

In another embodiment of the procedure, an on-line version of the procedure with a controlled delay can be implemented by segmentation of the input signal in portions and by applying the off-line version of the procedure to each portion of the input signal.

Another aspect of the invention refers to a system comprising means to perform the method for QPI reduction of the invention previously explained. In other words, said system comprise processing means (for example, one or more electronic processor) capable to carry out the procedure for QPI reduction of the invention. Said system may also comprise means for acquiring electrical signals; means for analog-to-digital conversion of the acquired electrical signal and means for storage, transmission, processing or displaying the output signal after the application of the procedure for QPI reduction of the invention. More particularly, in an embodiment the proposed system may comprise:

- electrodes or transducers to capture the input analog signal (for example, a biopotential as an EEG signal or any other);
- an instrumentation pre-amplifier to prepare the signal for the analog-to-digital conversion;
- an analog-to-digital converter to transform the analog signal into a digital signal;
- means for transmission of the recorded digital signal from the analog-to-digital converter to a processing electronic device performing the method. In an embodiment, this transmission is made through a wire (e.g. the computer/processor is co-located with the device measuring the input signal), but in other embodiments the transmission is made through one or more wireless networks (for example, mobile networks);
- a processing electronic device (i.e. a computer or more generally speaking one or more electronic processors) where the digital signal is processed by carrying out the steps of the procedure for QPI reduction. In an embodiment, there will be one processor performing several or all the steps, but in other embodiments, each step may be performed by different processors (e.g. communicated by a communication network);
- and means for storage, transmission, processing or display the resulting output signal after the QPI reduction.

Examples of means for transmission of the recorded signal from the analog-to-digital converter and the processor comprise data transmission based on USB, WIFI, Bluetooth, or any other.

Examples of means for implementing the procedure of the invention comprise any processor with enough capability for execution of program instructions implementing the procedure of the invention, including computers, digital signal processors, microcontrollers, etc.

Finally, examples of means for storage, transmission, processing or display for the output signal after the QPI reduction, include commercial or research storage media, networks and communication protocols for data storage, data interchange, and data output media for information representation, including display screens, printers, etc.

The description of the present invention is complemented with code which implements one embodiment of the proposed procedure. The description of the invention is also complemented with some examples of signals (biopotentials), affected by QPI (particularly, the biopotentials in the examples are affected by PLI), which have been processed with the proposed procedure in order to reduce the QPI.

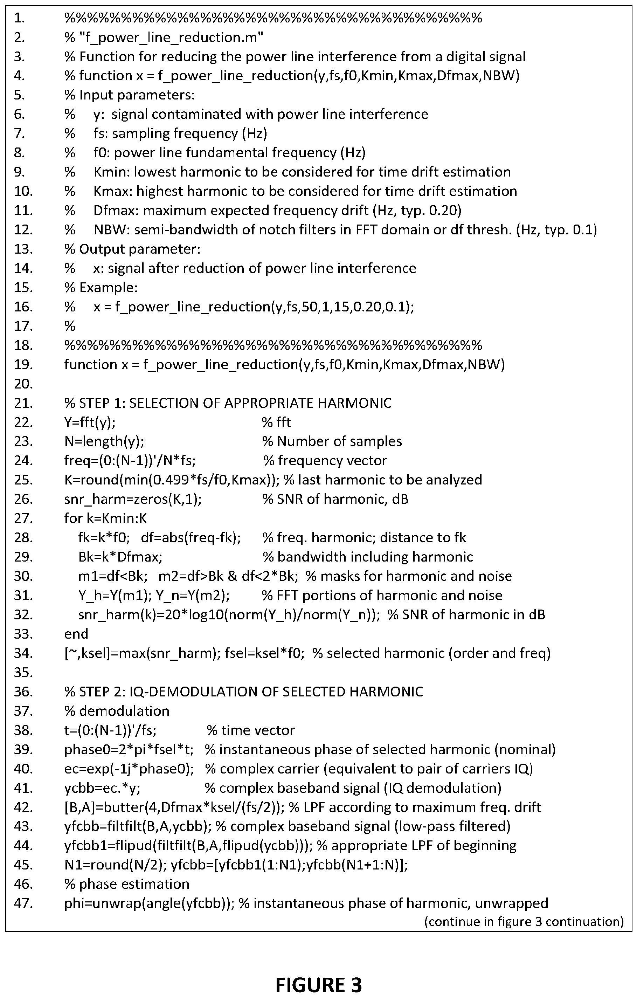

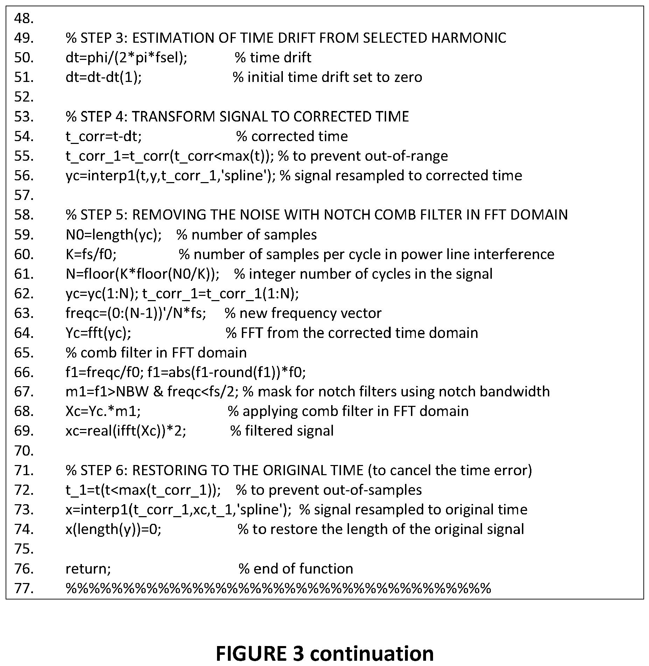

In order to better describe the present invention, one embodiment of the procedure of the invention has been developed and tested using MATLAB® for MS-Windows®. One example of implementation of the procedure of the invention using MATLAB® is provided in FIGURE 3 (this is only a non-limitative example made for testing purposes; the proposed procedure can be implemented in many other ways and using many other tools different form MATLAB®).

FIGURE 3 (see figures 3A and 3B) includes the listing of an M-file (implemented as a MATLAB® function or M-function) with instructions that provide off-line QPI reduction from a digital signal y[n] for a given configuration specifying: the sampling frequency $f_s$, the nominal fundamental frequency of the QPI $f_0$, the range of harmonics to be considered for the harmonic selection, the maximum expected frequency drift and the semi-bandwidth (or spectral threshold) for the notch filters in the frequency domain. The function provides as output the clean digital signal x[n] after the QPI reduction. This code is developed to test the procedure for QPI reduction in examples of biopotentials affected by interference from the power line (PLI).

In order to better explain the present invention, it will be presented now an example, where the proposed procedure has been applied to an ECG signal affected by PLI. The application of the proposed procedure to this ECG signal is described in detail in the following as a non-limitative example of the disclosed procedure.

In this example, the electrode configuration and the acquisition system corresponds to the diagram represented in FIGURE 1. For the acquisition of the ECG signal, the active and reference electrodes were placed on the chest of the subject, in the precordial positions V4 and V4r, respectively, and the ground electrode was allocated in the right wrist. The signal from the electrodes was conditioned with a single-channel instrumentation preamplifier by connecting the V4 and V4r electrodes to the differential input and the ground electrode (on the wrist) to the ground input. The preamplified signal y(t) was digitized by an analog-to-digital converter at a sampling frequency $f_s$=4 kHz, and the digital signal y[n] was transferred and stored into the computer.

The PLI reduction of the ECG in the signal y[n] was performed using the M-function reported in FIGURE 3, according to the procedure of the invention previously described and schematically represented in FIGURE 2. The PLI reduction was performed with appropriate configuration of the sampling rate ($f_s$=4000 Hz) and the PLI frequency ($f_0$=50 Hz), by searching all the available harmonics (Kmin=1, Kmax=40), with a maximum frequency drift at the fundamental frequency Dfmax=0.2 Hz, and semi-bandwidth of the notch filters NBW=0.1 Hz.

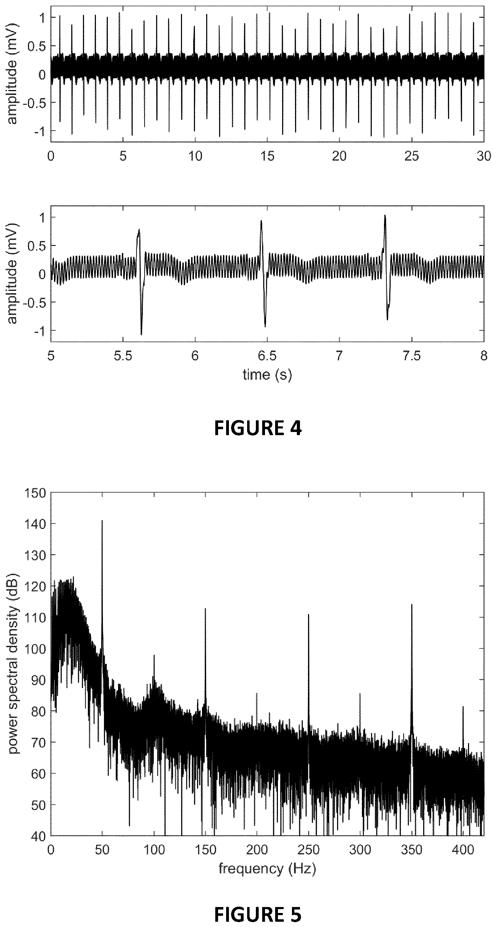

The ECG signal, represented in FIGURE 4, is severely affected by PLI, which can be observed as a 50 Hz periodic oscillation superimposed to the biopotential. In the upper panel of FIGURE 4, 30 seconds of ECG are represented, and 34 heartbeats are observed (beat period: 880 ms; beat rate: 68 beats per minute). The heart beats can easily be identified, each one with a clear QRS complex (high amplitude peaks); in other words, the peaks with maximum amplitude at each heartbeat correspond to the QRS complex. The bottom panel of FIGURE 4 shows a detail of the ECG signal, with a duration of 3 seconds, where 3 heartbeats are observed. At each heartbeat, the QRS complex can be identified, as well as the T wave (negative wave after the QRS complex). The P wave (positive wave before the QRS complex) is difficult to be observed. The observation of the waves is difficult due to the PLI (the PLI can be identified as 50 Hz oscillations superimposed to the biopotential). The polarity of the waves is consistent with the allocation of the electrodes.

The PLI is clearly observed in the frequency domain. The power spectral density (obtained from the DFT Y[m] of the ECG signal y[n]) is represented in FIGURE 5. In this figure, the harmonics of the PLI are observed at 50 Hz (fundamental frequency), 100 Hz (2nd harmonic), 150 Hz (3rd harmonic), 200 Hz (4rd harmonic), 250 Hz (5rd harmonic), 300 Hz (6rd harmonic), 350 Hz (7rd harmonic) and 400 Hz (8rd harmonic) with the typical prevalence of the odd harmonics with respect to even harmonics.

Step 1 of the procedure of the invention analyzes the spectrum Y[m] of the ECG y[n], in order to select the PLI harmonic with highest SNR (power of the harmonic over power of the noise around the harmonic). The harmonics were explored from the 1st (fundamental frequency) to the last one (below $f_s/2$). The selected harmonic with the highest SNR was the 7th (350 Hz) with a SNR of 30.96 dB, and therefore $k_{sel}$=7. In this case, only one harmonic has been selected (i.e. H=1).

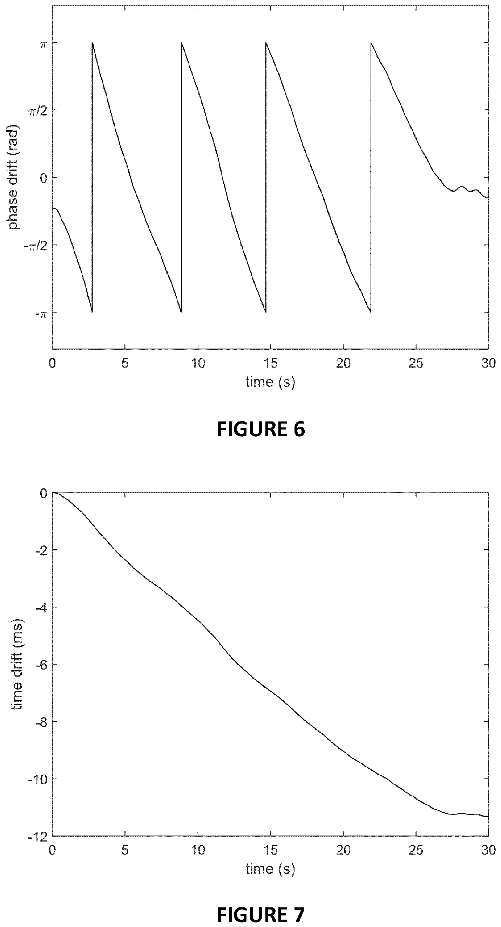

Step 2 of the procedure of the invention performs a quadrature phase demodulation of the ECG y[n] using a carrier of the selected harmonic. This operation was performed by multiplying the signal y[n] with a complex carrier of 350 Hz. According to the maximum expected frequency drift, the complex base-band signal was low-pass filtered (with a cutoff frequency 0.2Hz·$k_{sel}$=1.4 Hz), and the estimated phase drift provided by this step is the angle (or phase, or argument) of the complex signal $y_{fcbb}$[n] (the filtered complex base-band signal). The phase drift estimated from y[n] at the 7th harmonic (with respect to the nominal frequency of 350 Hz) is represented, as a function of the time, in FIGURE 6. This figure represents the phase drift before the unwrapping, and four jumps of $2\pi$ radians are observed.

Step 3 of the procedure of the invention provides the time drift dt[n], estimated from the phase drift and the selected harmonic. This time drift is represented in FIGURE 7. Interestingly, the time drift is similar for all the harmonics (the difference is associated to the noise contaminating the spectral region around the harmonics). The slope of the phase drift and time drift reveals a global bias in the frequency of the PLI with respect to the nominal frequency (around -15 mHz for the fundamental frequency), and the non-constant slope also reveals fluctuations of this instantaneous frequency (in the range [-30, +5] mHz).

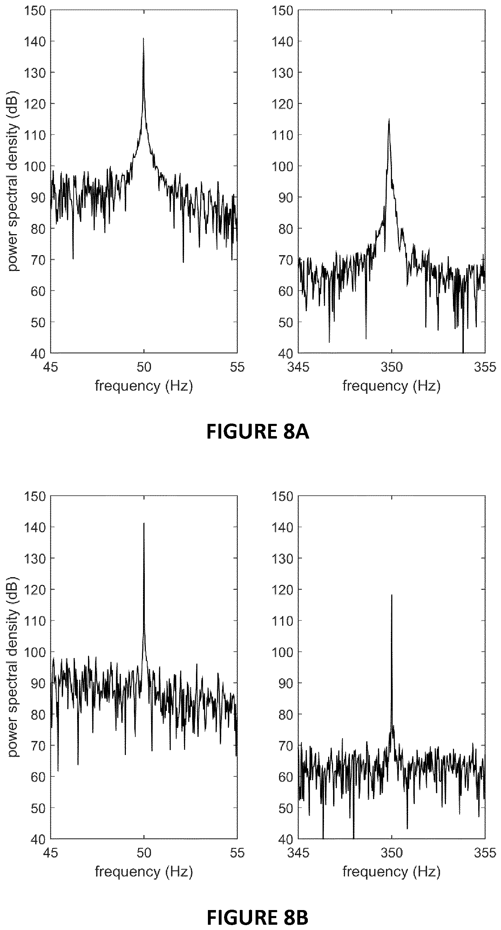

The time drift dt[n] is cancelled in the signal in step 4. FIGURE 8 compares two harmonics (fundamental frequency, at 50 Hz, and 7th at 350 Hz) before and after the cancellation of the time drift (FIGURES 8A and 8B, respectively), by including the corresponding portions of the power spectral density estimated from y[n] and $y_c$[n]. Due to the phase drift (and the associated frequency drift), Before the correction of the time drift, the energy of the harmonics is spread around their corresponding nominal frequencies a relatively wide frequency range (FIGURE 8A). After the cancellation of the estimated time drift, the phase drift (and the associated frequency drift) is compensated, so the frequency fluctuation is cancelled and the energy of the harmonics is concentrated at their corresponding nominal frequencies (FIGURE 8B) allowing the PLI reduction with minimal distortion of the signal of interest.

According to step 5, the PLI is reduced by making null those spectral components in $Y_c$[m] (the Fourier transform of $y_c$[n]) at a distance smaller than 0.1 Hz to the nominal frequency of each harmonic. Thanks to the time drift cancellation (and the concentration of the harmonics at their nominal frequency) the reduction of the PLI is effective even with a cancellation of so few spectral components (which provides effective PLI reduction with minimal distortion of the signal).

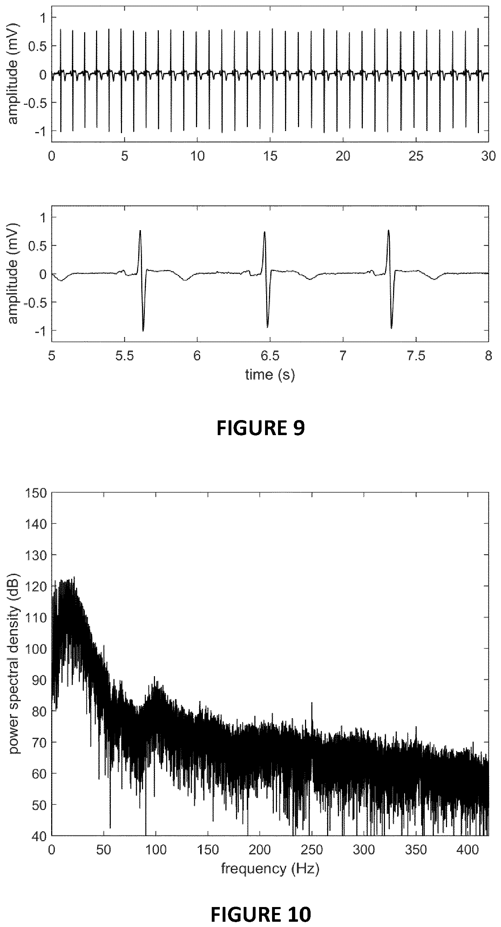

Finally, in step 6, the clean signal after the PLI reduction is transformed back to the original time scale. FIGURE 9 represents the ECG signal x[n] after the PLI reduction and transformed to the original time scale (the complete signal with 30 seconds in the top panel, and a detail of 3 seconds in the bottom panel). After the PLI reduction, the quality of the ECG significantly improves with respect to that in FIGURE 4. The waveform is very replicable at the different heart beats and the waves are clearly identifiable at each heart beat: QRS complex (high amplitude peaks), wave P (low amplitude positive wave before the QRS complex), and wave T (negative wave after the QRS complex), with an appearance of the waves consistent with the allocation of the active and reference recording electrodes, placed on the chest at the precordial positions V4 and Vr4, respectively (the ground electrode was allocated on the right wrist). After the PLI reduction, no residual PLI is observed in the signal x[n].

Similarly, the reduction of the PLI can be evaluated by comparing the PSD of x[n] in FIGURE 10 with the PSD of y[n] in FIGURE 5. The harmonics associated to the PLI are not present after the application of the procedure for PLI reduction.

The proposed procedure for PLI reduction has been compared with other method for PLI reduction, consisting in the application of an IIR notch comb filter tuned to the harmonics of the PLI. Two IIR notch comb filters have been designed with the standard MATLAB®-function iircomb(). A critical parameter of such filters is the quality factor or Q factor. A high quality factor provides narrow bandwidths to be removed, therefore causing smaller distortion but less effective PLI reduction if the harmonics are spread around their nominal frequencies. As the quality factor is lower, the removed bandwidth is wider, and the PLI reduction is more effective but the filter causes more important distortion to the signal.

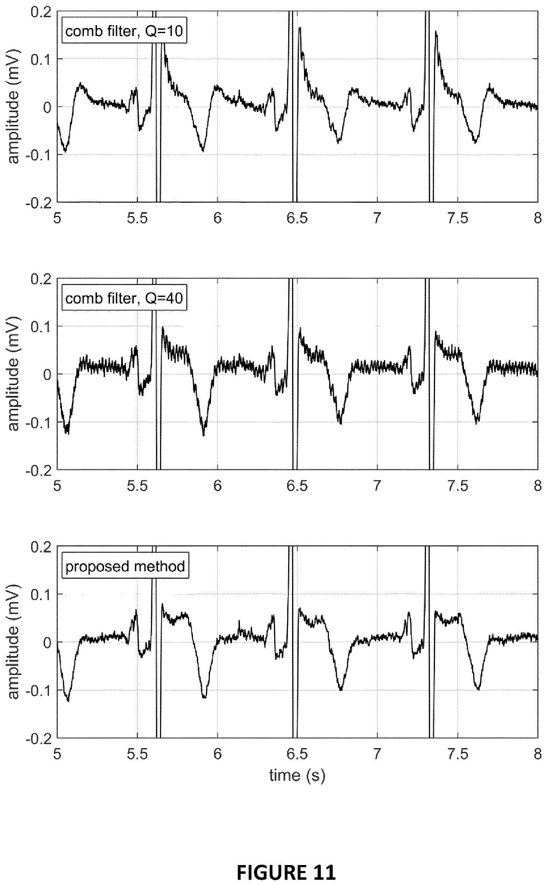

FIGURE 11 compares the result of three PLI reduction procedures: (1) based on IIR notch comb filter with Q=10 (upper panel), (2) based on IIR notch comb filter with Q=40 (lower panel), and (3) the proposed PLI reduction procedure of the invention (bottom panel). A detail of the ECG signals is represented for a better comparison. When the notch comb filters are applied, the result strongly depends on the quality factor Q. A small quality factor (Q=10, top panel) provides the attenuation of a wide band around each harmonic, and consequently the PLI is efficiently removed, but important distortion is generated to the recovered signal (an abnormal transitory evolution is generated after the P, QRS and T components, known as ringing artifact, and also the T waves become attenuated). A large quality factor (Q=40, central panel) provides the attenuation of a narrow band around each harmonic, and consequently the distortion effect is smaller, but the reduction of the PLI is insufficient (a remaining 50 Hz oscillation is clearly observed). The proposed procedure (bottom panel) provides narrow-band filtering of the PLI in the corrected time scale, therefore providing minimum distortion and efficient PLI cancellation simultaneously.

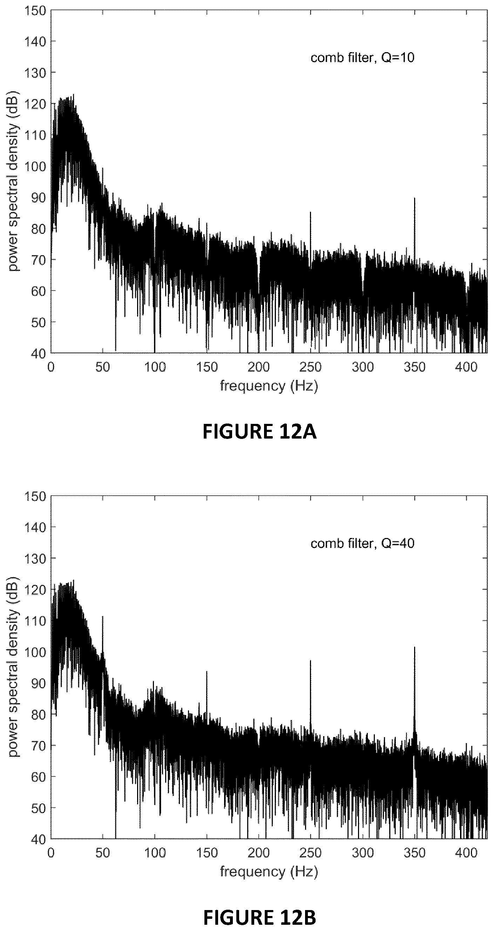

The effect of the quality factor with the IIR notch comb filters can also be observed in the PSD of the signals after the PLI reduction. FIGURE 12 represents the PSD of the ECG signals after PLI reduction based on IIR notch comb filters using Q-factor equal to 10 (FIGURE 12A) and Q-factor equal to 40 (FIGURE 12B). Since the harmonics of the PLI are spread around their respective nominal frequencies, it is not possible to provide simultaneously low distortion (requiring narrow bandwidth) and efficient PLI reduction (requiring wide bandwidth).

In order to better explain the present invention, a second example is described below, where the implemented procedure of the invention has been applied to an EEG signal (also affected by PLI) recorded for the estimation of auditory evoked potentials (electrical responses of the nervous system to auditory stimuli). The application of the proposed procedure to this EEG signal is described in detail in the following, also as a non-limitative example of the disclosed procedure.

In this specific example, the ground electrode was allocated on the middle forehead of the explored subject, and the active and reference electrodes for the acquisition of the EEG signal were allocated, respectively, on the upper forehead (Fz) and on the right mastoid (Tp10). The signal from the electrodes was conditioned by a single-channel instrumentation preamplifier by connecting the Fz and Tp10 electrodes to the differential input and the ground electrode to the ground input. The preamplified signal was digitized by an analog-to-digital converter at sampling frequency $f_s$=16 kHz, and the digital signal was transferred and stored into the computer.

For the estimation of the evoked potentials, a sequence of auditory stimuli was presented to the subject. The stimuli consisted in rarefaction clicks of 0.1 ms, presented at a randomized stimulation rate with random inter-stimulus-interval in the range 15-30 ms (average stimulation rate 44.4 stimuli per second). The stimulation level was randomly selected in the range 40-80 dB NHL (normal hearing level) in steps of 10 dB. The stimuli were presented through calibrated headphones, and during the recording procedure, the instants when the stimuli were presented were registered in order to allow the synchronous average of the responses. Since the evoked responses are longer than the inter-stimulus-interval (and then the responses are overlapped), the evoked responses are estimated by a deconvolution procedure (instead of a simple synchronous average). A total of 20.000 click stimuli were presented to the subject (4.000 stimuli for each stimulation level). The total recording procedure was organized in 20 segments. Each segment had a duration of 24 seconds and includes the responses to 1.000 stimuli (22.5 seconds including the stimuli, increased with 0.5 and 1.0 seconds of recording at the beginning and end of each segment). The experimental design is similar to that described in document "Multi-response deconvolution of auditory evoked potentials in a reduced representation space" by De la Torre et al.

The PLI reduction of the EEG signal y[n] was performed using the M-function reported in FIGURE 3, according to the procedure of the invention described and represented in FIGURE 2. The PLI reduction was performed with appropriate configuration of the sampling rate ($f_s$=16 kHz) and the PLI frequency ($f_0$=50 Hz), by searching the optimal harmonics in the range 250-2500 Hz (Kmin=5, Kmax=50), with a maximum frequency drift at the fundamental frequency Dfmax=0.2 Hz, and semi-bandwidth of the notch filters NBW=0.1 Hz.

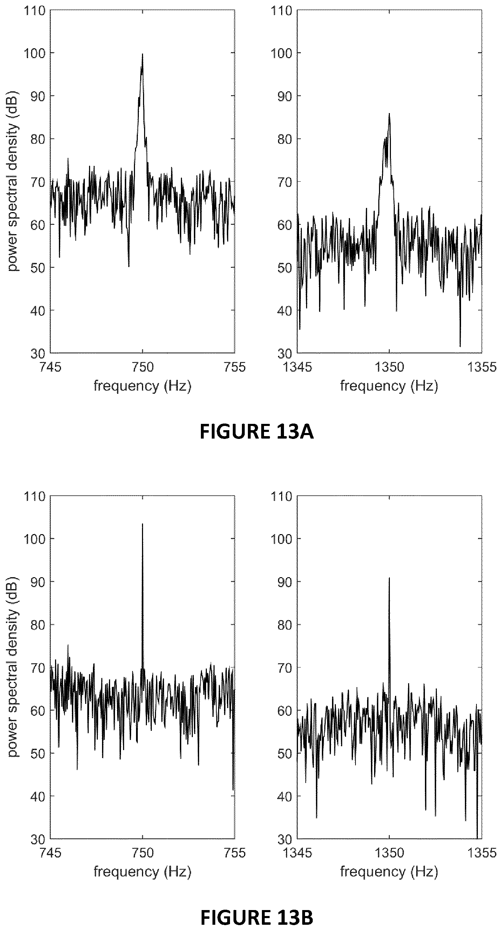

After the analysis of the spectrum Y[m] of the EEG (for the first segment of 24 seconds), the selected harmonic in step 1 of the procedure was $k_{sel}$=15 (750 Hz) with a SNR of 15.12 dB. FIGURE 13 represents two harmonics (the 15th and 27th, at 750 Hz and 1350 Hz, respectively, in the left and right panels) before and after the cancellation of the time drift. Before the cancellation (correction) of the time drift, the harmonics are spread around a wide range of frequency (FIGURE 13A) around their corresponding nominal frequencies, due to the phase and frequency drift. After the cancellation of the estimated time drift, the phase drift (and the associated frequency drift) is compensated so the frequency fluctuation is cancelled and the energy of the harmonics is concentrated at their respective nominal frequencies (FIGURE 13B), which allows an efficient cancellation of the PLI with minimal distortion of the signal.

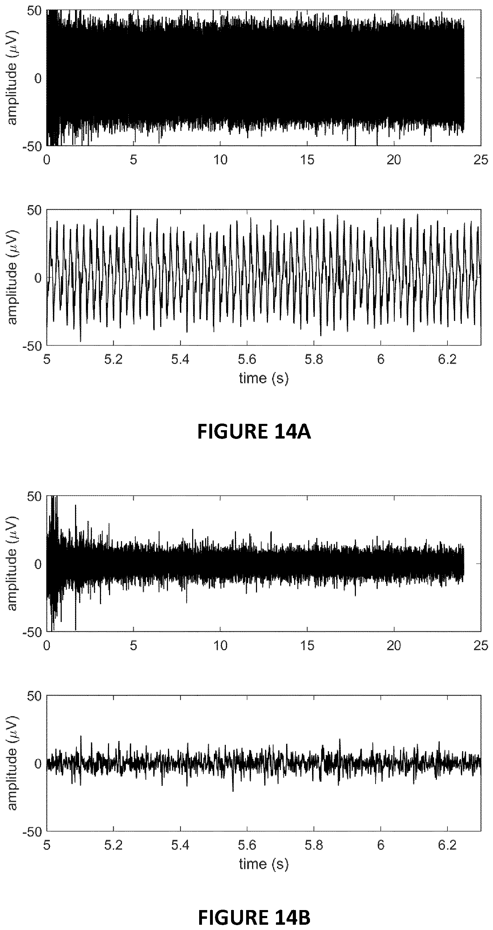

FIGURE 14 compares the EEGs before (y[n], FIGURE 14A) and after (x[n], FIGURE 14B) the cancellation of the PLI (for the first segment of the EEG). The upper panel of each figure represents the complete segment with 24 seconds, while the bottom panel represents a detail with duration of 1.3 seconds. Before the application of the procedure, the PLI is clearly observed as a 50 Hz oscillation. As observed in FIGURE 14B, this oscillation is removed by the proposed procedure. The signal x[n] after the PLI cancellation contains the stimulation artifact, the evoked response (components of interest), and other types of noise (brain activity, muscle activity, etc). The cancellation of the harmonics of 50 Hz provided a substantial reduction of the rms (root mean square) amplitude in the EEG, from 14.58 uV rms (before) to 3.61 uV rms (after the PLI cancellation), i.e. providing a reduction of 12.13 dB in the amplitude of the EEG.

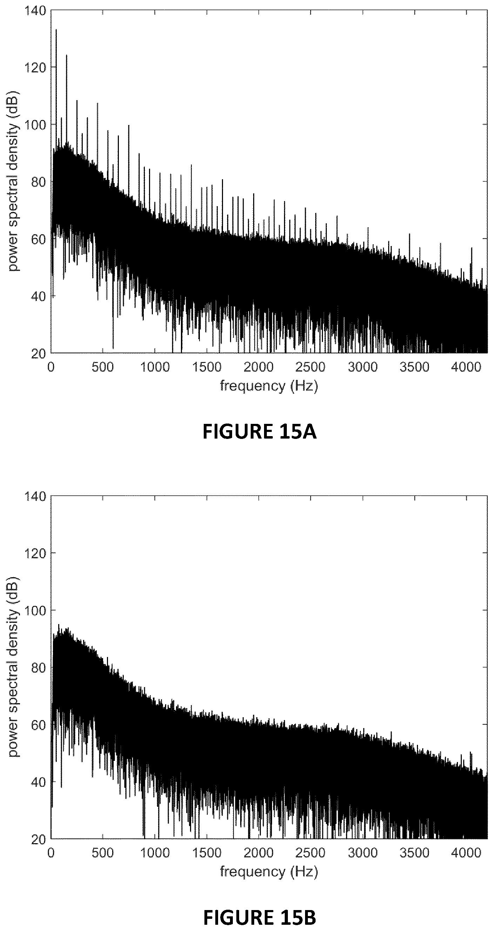

FIGURE 15 compares the PSD of the EEG before and after the PLI cancellation. The harmonics of the PLI can easily be observed before the application of the procedure (FIGURE 15A). They are not present after the application of the PLI cancellation procedure (FIGURE 15B).

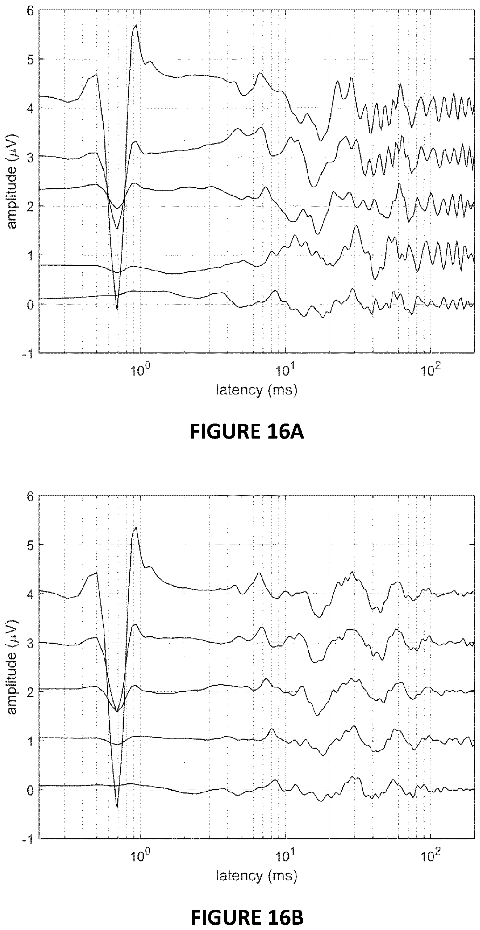

Finally, FIGURE 16 represents the deconvolved evoked responses generated with short click auditory stimuli of different intensities, obtained from the 20 segments of recorded EEG. FIGURE 16A includes the evoked responses estimated from the original EEG (before the application of the PLI cancelation procedure), while FIGURE 16B includes the evoked responses estimated from the processed EEG (after the cancellation of the PLI).Each figure includes 5 plots corresponding to the evoked responses obtained at different stimulation levels of 80, 70, 60, 50 and 40 dB NHL (from top to bottom). The plots represent the amplitude of the evoked responses (in microvolts) as a function of the latency (in ms) from the presentation of the stimulus. The latency axis is logarithmically compressed in order to simultaneously visualize the different components of the evoked responses. In these plots, the stimulation artifact can be observed before the first ms; the components of the auditory brainstem response (most peripheral evoked response) can be observed in the portion 1-10 ms of latency (wave III can be identified at a latency around 4.5-5 ms; wave V around 6.5-8.5 ms), and middle latency response components (P0, Pa, Pb) are observed in the latency interval 10-100 ms. The identification of the waves is significantly easier (and the quality of the estimated responses is significantly better) after the PLI cancelation.

Summarizing, the proposed invention is focused on the cancellation of the QPI frequency drift, in order to minimize the spectral width of the interference harmonics and, therefore, to efficiently reduce this interference (i.e. reduction of the QPI components with minimum distortion of the signal of interest). The procedure selects QPI harmonics suitable for the estimation of a time drift associated to the frequency drift; estimates the time drift; transforms the signal to a time-scale where the time drift (and therefore also the frequency drift) is cancelled; efficiently reduces the QPI components with minimal distortion of the signal; and transforms the signal back to the original time-scale. The procedure provides a signal substantially free of QPI.

Definitions

Electrical signal: An electrical magnitude, with a value depending on the time that carries information. Biopotentials (such as electrocardiograms, electroencephalograms, electromiograms, neural action potentials, electroóculo-

grams...), instrumentation signals (provided by transducers), etc. are particular cases of electrical signals.

Quasi-periodic interference (QPI): A particular type of noise caused by a quasi-periodic source of interference with a specific nominal fundamental frequency, characterized by fluctuations of frequency, phase and/or amplitude, and with significant spectral power at one or several harmonics of its fundamental frequency.

Power line interference (PLI): A particular type of QPI affecting electrical signals, caused by the power line and its interference over the electrical or electronic system for the acquisition, amplification or processing of the electrical signal, and characterized by a quasi-periodicity around the nominal frequency of the power line. Its nominal fundamental frequency is country-dependent and takes a typical value of either 50 or 60 Hz, but generally speaking it can take any other values for its fundamental frequency. Digital signal: Numerical representation of the electrical signal after a process of analog-to-digital conversion (ADC) using a specific sampling rate.

### Notation

In the description of the invention, the analog electrical signals will be noted as x(t), y(t), etc., that is, as a function of the time. The digital signals, acquired at a given sampling rate $f_s$, will be noted as x[n], y[n], etc., being n the sample index, and verifying that

$$x[n]=x(t_n), \text{ with } t_n=n/f_s.$$

In the description of the invention, digital signals of finite duration are considered, and therefore their spectral analysis may be based on discrete Fourier transform (DFT). The DFT of a signal x[n] will be noted as X[m], being m the index of the spectral component.

In the description of the invention, the noisy signals (i.e. the signals affected by the QPI) will be noted with "y" (y(t), y[n], Y[m]) while the clean signals (after the reduction of the QPI) will be noted with "x" (x(t), x[n], X[m]).

The nominal frequency of the QPI will be noted as $f_0$. In the case of power line interference (PLI), the value of $f_0$ is either 50 Hz or 60 Hz, depending on the country.

### References

### Patent documents:

- US patent 9247911B2 (2016)
- US patent 8761867B2 (2014)
- PCT application WO2020197490A
- US patent 5278777A (1994)
- US patent 7894885B2 (2011)

### Other publications:

- Medina-Rodriguez et al., (2014): "Improved multifrequency phase-modulation method that uses rectangular-wave signals to increase accuracy in luminescence spectroscopy". Analytical Chemistry, Vol. 86, p. 5245-5256, 2014.
- Medina-Rodriguez et al., (2016): "Direct estimation of the standard error in phase-resolved luminescence measurements. Application to an oxygen measuring system". Sensors and Actuators B, Vol. 224, p. 521-528, 2016.
- Medina-Rodriguez et al., (2017): "Real-time optimal combination of multifrequency information in phase-resolved luminescence spectroscopy based on rectangular-wave signals". Sensors and Actuators B, Vol. 238, p. 221-225, 2017.
- De la Torre et al., (2024): "Multi-response deconvolution of auditory evoked potentials in a reduced representation space". J. Acoust. Soc. Am. Vol. 155(6), p. 3639-3653, 2024.

### Claims

**1.** A method to reduce a quasi-periodic interference (QPI) of nominal fundamental frequency $f_0$ from an input digital signal y[n] digitized at a sampling rate $f_s$, comprising:

A) Estimating a time drift dt[n] of the QPI;

B) Compensating the estimated time drift dt[n] by transforming the time scale of the digital input signal from its original time scale to a corrected time scale based on the estimated time drift dt[n], obtaining a signal $y_c$[n] in the corrected time scale;

C) Cancelling harmonics of the QPI from the signal in the corrected time scale $y_c$[n], either by applying notch filters tuned at $f_0$ and its harmonics in the time domain, or by cancelling frequency components corresponding to $f_0$ and its harmonics in the frequency domain, obtaining a signal $x_c$[n] in the corrected time scale;

D) Transforming the signal $x_c$[n] from the corrected time scale to the original time scale obtaining a signal x[n] in the original time scale.

2. The method of claim 1, where the estimation of the time drift dt[n] in step A comprises:

1) Selecting one or more harmonics, $k_{sel}$, to be used for the estimation of the phase drift of the QPI, being the selected harmonics the harmonics with the highest signal-to-noise ratio SNR, where $k_{sel}= k_{sel1}\ k_{sel2...}\ k_{selH}$ are the indexes of the selected harmonics and H>=1 is the number of harmonics selected;

2) For each selected harmonic h, h=1... H, estimating the phase drift, $\varphi_h$[n], of the QPI with respect to the nominal frequency, $k_{selh}\cdot f_0$, by applying a digital phase demodulation procedure applied to the band around the nominal frequency;

3) Calculating the time drift, $dt_h$[n], associated to the phase drift estimated for each selected harmonic h, h=1... H as:

$$dt_h[n] = \varphi_h[n]/(2\cdot\pi\cdot k_{selh}\cdot f_0)$$

and determining the estimated time drift, dt[n], of the QPI as the average or the weighted average of the calculated time drifts for the selected harmonics.

3. The method of claim 2, wherein the selection of one or more harmonics to be used for the phase drift estimation of step 1, comprises:

1.a) Computing the Discrete Fourier Transform (DFT) Y[m] of the input digital signal y[n];

1.b) For each harmonic k, defining a maximum expected frequency excursion $B_k$ of the harmonic with respect to its nominal frequency $k\cdot f_0$;

1.c) For each harmonic k, estimating the energy of the harmonic $E_k$ from the frequency components in the interval $[k\cdot f_0 \pm B_k]$, and to estimate the energy of the noise affecting the harmonic $E_{nk}$ from the frequency components in the intervals $[k\cdot f_0 - 2\cdot B_k,\ k\cdot f_0 - B_k]$ and $[k\cdot f_0 + B_k,\ k\cdot f_0 + 2\cdot B_k]$;

1.d) For each harmonic k, estimating the signal-to-noise ratio, SNR as the ratio of the harmonic energy to the noise energy, $SNR_k = E_k/E_{nk}$;

1.e) Selecting the harmonics with the highest $SNR_k$.

4. The procedure according to any of the previous claims 2-3, wherein the phase drift estimation for each selected harmonic h, h=1... H, is based on a quadrature phase demodulation of the signal y[n] around the carrier $k_{selh}\cdot f_0$, using a pair of carriers of frequency $k_{selh}\cdot f_0$ in quadrature, comprising the following steps:

2.a) Obtaining the base-band in-phase component $y_i$[n] by multiplying the digital signal y[n] with the in-phase carrier $\cos(2\cdot\pi\cdot k_{selh}\cdot f_0\cdot n/f_s)$ and obtaining the base-band quadrature component $y_q$[n] by multiplying the digital signal y[n] with the quadrature carrier $-\sin(2\cdot\pi\cdot k_{selh}\cdot f_0\cdot n/f_s)$;

2.b) Combining the in-phase and quadrature base-band components into the complex base-band signal $y_{cbb}$[n] =$y_i$[n] + j·$y_q$[n], being j the imaginary unit of the complex numbers;

2.c) Filtering the complex base-band signal using a low-pass filter with an appropriate cut-off frequency equal to the maximum expected frequency excursion for said harmonic, therefore obtaining the filtered complex base-band signal $y_{fcbb}$[n];

2.d) Estimating the phase drift $\varphi_h$[n] for said harmonic as the phase (or argument) of the filtered complex base-band signal $y_{fcbb}$[n] as:

$$\varphi_h[n] = atan(imag(y_{fcbb}[n])/real(y_{fcbb}[n])) \quad or \quad \varphi_h[n] = angle(y_{fcbb}[n])$$

2.e) Unwrapping the phase drift $\varphi_h$[n] in order to provide continuity to the estimated phase and avoid phase jumps.

5. The method according to any of the previous claims 2-4, wherein the time drift dt[n] is estimated as the weighted average of the time drift estimations from each selected harmonic, with weights proportional to the SNR of each selected harmonic, preferably, proportional to the SNR of each selected harmonic and to the square of the harmonic index.

6. The method according to any of the previous claims, wherein the compensation of the estimated time drift in step B, comprises the following steps:

> B.a) For each sample n of the signal, estimating the original time t[n] and the corrected time $t_c$[n], respectively, as: t[n] = n/$f_s$ and $t_c$[n] = t[n]-dt[n];
> B.b) From the pairs (t[n],y[n]) and using the corrected time $t_c$[n], estimating the signal in the corrected time scale $y_c$[n] by interpolation.

7. The method according to any of the previous claims, wherein the cancellation of the harmonics of the QPI from the signal $y_c$[n] in the corrected time scale in step C, comprises the following steps:

> C.a) Obtaining the spectrum of the signal in the corrected time scale $Y_c$[m] by applying a DFT to the signal in the corrected time scale $y_c$[n].
> C.b) Defining a spectral threshold df as the maximum expected semi-width of the harmonics after the cancellation of the time drift, the spectral threshold df being at least half of the inverse of the duration of the signal y[n], and removing the harmonics of the QPI by making null those spectral components in the spectrum $Y_c$[m] at a spectral distance to the frequency of each harmonic k, k·$f_0$, smaller than the threshold df, providing a spectrum in the corrected time scale $X_c$[m];.
> C.c) Obtaining the signal in the corrected time scale $x_c$[n] by applying an inverse discrete Fourier transform, iDFT, to the spectrum $X_c$[m].

8. The method according to any of the previous claims, wherein the transformation of the signal from the corrected time scale $x_c$[n] to the original time scale x[n] in step D is obtained by interpolation from the pairs ($t_c$[n],$x_c$[n]) and using the original time values t[n], where, t[n] = n/$f_s$ and $t_c$[n] = t[n]-dt[n].

9. The method according to any of the previous claims, wherein the compensation of the estimated time drift in step B and/or the transformation of the signal from the corrected time scale to the original time scale in step D is based on cubic spline interpolation.

10. The method according to any of the previous claims, wherein the method is performed as an off-line algorithm, that is, each step of the method is performed after the previous step is completed for the complete signal to be processed.

11. The method according to any of the previous claims, wherein the method is performed as an on-line algorithm, that is each step is applied up to the current available samples of its input signal with some delay depending on the cumulated delay caused in each step.

12. The method according to claim 11, wherein the on-line version is implemented by segmentation of the input signal into portions and by applying the off-line version of the procedure to each portion of the input signal.

13. Computer program comprising instructions for making a computer or any other information processing system carry out the method according to any of the claims 1 to 12.

14. Computer-readable storage medium comprising program instructions capable of making a computer to carry out the method according to any of the claims 1 to 12.

15. System for acquisition of an electrical signal including the means to carry out the procedure for QPI reduction of the invention, the system comprising: means for acquiring electrical signals; means for analog-to-digital conversion of the acquired electrical signal obtaining digital input signal y[n]; processing means capable to carry out the procedure for QPI reduction of the invention according to any of the claims 1 to 12; and means for storage, transmission, processing and/or displaying the output signal of the method.

**FIGURE 1**

**FIGURE 2**

```
%%%%%%%%%%%%%%%%%%%%%%%%%%%%%%%%%%%%%
% "f_power_line_reduction.m"
% Function for reducing the power line interference from a digital signal
% function x = f_power_line_reduction(y,fs,f0,Kmin,Kmax,Dfmax,NBW)
% Input parameters:
%    y:  signal contaminated with power line interference
%    fs: sampling frequency (Hz)
%    f0: power line fundamental frequency (Hz)
%    Kmin: lowest harmonic to be considered for time drift estimation
%    Kmax: highest harmonic to be considered for time drift estimation
%    Dfmax: maximum expected frequency drift (Hz, typ. 0.20)
%    NBW: semi-bandwidth of notch filters in FFT domain or df thresh. (Hz, typ. 0.1)
% Output parameter:
%    x: signal after reduction of power line interference
% Example:
%    x = f_power_line_reduction(y,fs,50,1,15,0.20,0.1);
%
%%%%%%%%%%%%%%%%%%%%%%%%%%%%%%%%%%%%%
function x = f_power_line_reduction(y,fs,f0,Kmin,Kmax,Dfmax,NBW)

% STEP 1: SELECTION OF APPROPRIATE HARMONIC
Y=fft(y);                    % fft
N=length(y);                 % Number of samples
freq=(0:(N-1))'/N*fs;        % frequency vector
K=round(min(0.499*fs/f0,Kmax)); % last harmonic to be analyzed
snr_harm=zeros(K,1);         % SNR of harmonic, dB
for k=Kmin:K
    fk=k*f0;  df=abs(freq-fk);   % freq. harmonic; distance to fk
    Bk=k*Dfmax;                  % bandwidth including harmonic
    m1=df<Bk;  m2=df>Bk & df<2*Bk;  % masks for harmonic and noise
    Y_h=Y(m1); Y_n=Y(m2);        % FFT portions of harmonic and noise
    snr_harm(k)=20*log10(norm(Y_h)/norm(Y_n));  % SNR of harmonic in dB
end
[~,ksel]=max(snr_harm); fsel=ksel*f0;  % selected harmonic (order and freq)

% STEP 2: IQ-DEMODULATION OF SELECTED HARMONIC
% demodulation
t=(0:(N-1))'/fs;          % time vector
phase0=2*pi*fsel*t;   % instantaneous phase of selected harmonic (nominal)
ec=exp(-1j*phase0);   % complex carrier (equivalent to pair of carriers IQ)
ycbb=ec.*y;              % complex baseband signal (IQ demodulation)
[B,A]=butter(4,Dfmax*ksel/(fs/2)); % LPF according to maximum freq. drift
yfcbb=filtfilt(B,A,ycbb); % complex baseband signal (low-pass filtered)
yfcbb1=flipud(filtfilt(B,A,flipud(ycbb))); % appropriate LPF of beginning
N1=round(N/2); yfcbb=[yfcbb1(1:N1);yfcbb(N1+1:N)];
% phase estimation
phi=unwrap(angle(yfcbb)); % instantaneous phase of harmonic, unwrapped
```

(continue in figure 3 continuation)

FIGURE 3

```
% STEP 3: ESTIMATION OF TIME DRIFT FROM SELECTED HARMONIC
dt=phi/(2*pi*fsel);       % time drift
dt=dt-dt(1);              % initial time drift set to zero

% STEP 4: TRANSFORM SIGNAL TO CORRECTED TIME
t_corr=t-dt;              % corrected time
t_corr_1=t_corr(t_corr<max(t)); % to prevent out-of-range
yc=interp1(t,y,t_corr_1,'spline'); % signal resampled to corrected time

% STEP 5: REMOVING THE NOISE WITH NOTCH COMB FILTER IN FFT DOMAIN
N0=length(yc);   % number of samples
K=fs/f0;            % number of samples per cycle in power line interference
N=floor(K*floor(N0/K));   % integer number of cycles in the signal
yc=yc(1:N); t_corr_1=t_corr_1(1:N);
freqc=(0:(N-1))'/N*fs;    % new frequency vector
Yc=fft(yc);               % FFT from the corrected time domain
% comb filter in FFT domain
f1=freqc/f0; f1=abs(f1-round(f1))*f0;
m1=f1>NBW & freqc<fs/2; % mask for notch filters using notch bandwidth
Xc=Yc.*m1;                % applying comb filter in FFT domain
xc=real(ifft(Xc))*2;      % filtered signal

% STEP 6: RESTORING TO THE ORIGINAL TIME (to cancel the time error)
t_1=t(t<max(t_corr_1));   % to prevent out-of-samples
x=interp1(t_corr_1,xc,t_1,'spline');  % signal resampled to original time
x(length(y))=0;           % to restore the length of the original signal

return;                   % end of function
%%%%%%%%%%%%%%%%%%%%%%%%%%%%%%%%%%%%%%%%
```

# FIGURE 3 continuation

**FIGURE 4**

**FIGURE 5**

**FIGURE 6**

**FIGURE 7**

**FIGURE 8A**

**FIGURE 8B**

**FIGURE 9**

**FIGURE 10**

**FIGURE 11**

**FIGURE 12A**

**FIGURE 12B**

**FIGURE 13A**

**FIGURE 13B**

**FIGURE 14A**

**FIGURE 14B**

**FIGURE 15A**

**FIGURE 15B**

**FIGURE 16A**

**FIGURE 16B**

Europäisches
Patentamt

European
Patent Office

Office européen
des brevets

# EUROPEAN SEARCH REPORT

**Application Number**

EP 25 16 6854

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | AZAROV ELIAS ET AL: "Speech Enhancement in Quasi-Periodic Noises Using Improved Spectral Subtraction Based on Adaptive Sampling", 4 September 2015 (2015-09-04), SAT 2015 18TH INTERNATIONAL CONFERENCE, AUSTIN, TX, USA, SEPTEMBER 24-27, 2015; [LECTURE NOTES IN COMPUTER SCIENCE; LECT.NOTES COMPUTER], SPRINGER, BERLIN, HEIDELBERG, PAGE(S) 405 - 412, XP047319683, ISBN: 978-3-540-74549-5 [retrieved on 2015-09-04] * page 406, line 18 - line 24; figure 1 * * page 407, line 5 - line 20 * * page 407, line 22 - page 408, line 8 * * page 408, line 10 - line 24 * * page 409, line 4 - line 6 * * page 411, line 17 - line 25 * ----- | 1-15 | INV. A61B5/346 A61B5/372 A61B5/397 A61B5/00 |
| A | MISHRA SARITA ET AL: "A Power-Line Interference Canceler Based on Sliding DFT Phase Locking Scheme for ECG Signals", IEEE TRANSACTIONS ON INSTRUMENTATION AND MEASUREMENT, IEEE, USA, vol. 64, no. 1, 24 July 2014 (2014-07-24), pages 132-142, XP011566436, ISSN: 0018-9456, DOI: 10.1109/TIM.2014.2335920 [retrieved on 2014-12-05] * page 133 - page 137 * ----- -/-- | 1-15 | TECHNICAL FIELDS SEARCHED (IPC) A61B |

The present search report has been drawn up for all claims

| Place of search | Date of completion of the search | Examiner |
|---|---|---|
| The Hague | 23 May 2025 | Bourquin, Yannyk |

EPO FORM 1503 03.82 (P04C01)

Europäisches
Patentamt

European
Patent Office

Office européen
des brevets

## EUROPEAN SEARCH REPORT

**Application Number**

**EP 25 16 6854**

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | NEYCHEVA TATYANA ET AL: "Common-Mode Driven Synchronous Filtering of the Powerline Interference in ECG", APPLIED SCIENCES, [Online] vol. 12, no. 22, 8 November 2022 (2022-11-08), page 11328, XP093280225, ISSN: 2076-3417, DOI: 10.3390/app122211328 Retrieved from the Internet: URL:https://www.mdpi.com/2076-3417/12/22/11328/pdf> * page 4 - page 22 * ----- | 1-15 | |
| A | TOMASINI MARCO ET AL: "Power Line Interference Removal for High-Quality Continuous Biosignal Monitoring With Low-Power Wearable Devices", IEEE SENSORS JOURNAL, IEEE, vol. 16, no. 10, 15 May 2016 (2016-05-15), pages 3887-3895, XP011605911, ISSN: 1530-437X, DOI: 10.1109/JSEN.2016.2536363 [retrieved on 2016-04-08] * page 3889 - page 3894 * ----- | 1-15 | TECHNICAL FIELDS SEARCHED (IPC) |

The present search report has been drawn up for all claims

| Place of search | Date of completion of the search | Examiner |
|---|---|---|
| The Hague | 23 May 2025 | Bourquin, Yannyk |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 9247911 B2
- US 8761867 B2
- WO 2020197490 A
- US 5278777 A
- US 7894885 B2

**Non-patent literature cited in the description**

- **MEDINA-RODRIGUEZ et al.** *Direct estimation of the standard error in the phase-resolved luminescence measurements. Application to an oxygen measurement system*
- **MEDINA-RODRIGUEZ et al.** *Improved multifrequency phase-modulation method that uses rectangular-wave signals to increase accuracy in luminescence spectroscopy*
- **MEDINA-RODRIGUEZ.** *Real-time optimal combination of multifrequency information in phase-resolved luminescence spectroscopy based on rectangular-wave signals*
- **DE LA TORRE.** *Multi-response deconvolution of auditory evoked potentials in a reduced representation space*
- **MEDINA-RODRIGUEZ et al.** Improved multifrequency phase-modulation method that uses rectangular-wave signals to increase accuracy in luminescence spectroscopy. *Analytical Chemistry*, 2014, vol. 86, 5245-5256
- **MEDINA-RODRIGUEZ et al.** Direct estimation of the standard error in phase-resolved luminescence measurements. Application to an oxygen measuring system. *Sensors and Actuators B*, 2016, vol. 224, 521-528
- **MEDINA-RODRIGUEZ et al.** Real-time optimal combination of multifrequency information in phase-resolved luminescence spectroscopy based on rectangular-wave signals. *Sensors and Actuators B*, 2017, vol. 238, 221-225
- **DE LA TORRE et al.** Multi-response deconvolution of auditory evoked potentials in a reduced representation space. *J. Acoust. Soc. Am.*, 2024, vol. 155 (6), 3639-3653